(19) Europäisches Patentamt
European Patent Office
Office européen des brevets

(11) **EP 2 384 100 A2**

(12) **EUROPEAN PATENT APPLICATION**

(43) Date of publication:
02.11.2011 Bulletin 2011/44

(51) Int Cl.:
*H05K 1/05* (2006.01)  *C25D 11/12* (2006.01)
*C25D 11/16* (2006.01)  *H01L 33/64* (2010.01)
*H01L 33/60* (2010.01)

(21) Application number: 11164058.7

(22) Date of filing: 28.04.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 28.04.2010  JP 2010104527
30.06.2010  JP 2010150442
27.12.2010  JP 2010291243

(71) Applicant: Fujifilm Corporation
Minato-ku
Tokyo (JP)

(72) Inventors:
• Hotta, Yoshinori
Shizuoka (JP)
• Hatanaka, Yusuke
Shizuoka (JP)

(74) Representative: HOFFMANN EITLE
Patent- und Rechtsanwälte
Arabellastraße 4
81925 München (DE)

(54) **Insulated light-reflective substrate**

(57) An insulated light-reflective substrate, comprising a substrate and an anodized film provided on the surface of the substrate, wherein: the substrate has at its surface an aluminum alloy layer of a thickness of not less than 10 $\mu$m; the aluminum alloy layer has an aluminum purity of 99.9% by weight or higher, with the total content of Si and Fe in the layer being not more than 0.005% by weight, and the content of inevitable impurities in the layer as components other than Al, Si, Fe, Ga and Zn being not more than 0.01% by weight; the anodized film has micropores each extending from the surface of the film in the direction of thickness; and the ratio of center line length to depth of the micropores is 1.0 to 1.2.

EP 2 384 100 A2

**Description**

BACKGROUND OF THE INVENTION

The present invention relates to light-reflective substrates used for light-emitting devices, to be more specific, insulated light-reflective substrates used for light-emitting diode (hereafter referred to as "LED")-type light-emitting devices.

It is generally said about LEDs that their power consumption is one-hundredth of that of fluorescent lamps, and their life (40,000 hours) 40 times as long as that of fluorescent lamps. Such characteristics, being power-thrifty and long-life, are critical factors in choosing a LED with an environment-regarding tendency.

White LEDs in particular are increasingly expected as a light source for illumination because they are excellent in color rendering, and have the advantage of their power supply circuits simpler than those of fluorescent lamps.

In recent years, the white LEDs have successively emerged each of which has a high luminous efficacy (30 to 150 Lm/W) necessary to a light source for illumination, and surpasses fluorescent lamps (20 to 110 Lm/W) in light usage efficiency upon practical use.

For this reason, practical use of white LEDs instead of fluorescent lamps has drastically been accelerated, and white LEDs are increasingly employed as a backlight of a liquid crystal display or a light source for illumination.

It is indicated that, if a large current is passed through a LED chip in order to achieve a high luminance, the amount of heat generated will increase to promote the deterioration with time of a resin material carrying a phosphor for wavelength conversion, with a long life as a characteristic of LEDs being sacrificed.

In fact, conventional LEDs are disadvantageous in that a LED chip driven for a long time, or driven with a large current in order to increase the luminance of light emitted, generates considerable heat, with its temperature being so elevated as to cause thermal deterioration of the chip.

As a solution to such problem, it is proposed to provide the insulated substrate in which the surface of an aluminum substrate is coated with an anodized film (see JP 55-154564 U and JP 2007-251176 A, for instance). Apart from the insulating property of the anodized film, the aluminum substrate has a high thermal conductivity, so that a good heat dissipation is expected.

SUMMARY OF THE INVENTION

It, however, has been found that such an insulated substrate as described in JP 55-154564 U or JP 2007-251176 A may reduce the luminous efficacy of a LED depending on the purity of the aluminum substrate or the shape of micropores present in the anodized film, and it is difficult with the insulated substrate as such to achieve a high luminous efficacy while maintaining excellent insulation.

An object of the present invention is to provide an insulated light-reflective substrate capable of bringing about a light-emitting device excellent in both insulation and luminous efficacy, as well as a method of manufacturing such an insulated light-reflective substrate, and a light-emitting device with such an insulated light-reflective substrate used therein.

In order to achieve the above object, the inventors of the present invention made diligent researches, and found that excellent insulation and excellent luminous efficacies of a light-emitting device are made consistent with each other by using the substrate which includes a substrate having at its surface an aluminum alloy layer of a specified thickness composed of an aluminum alloy with a certain composition, and an anodized film having straight-cylindrical micropores, so as to complete the present invention.

In other words, the present invention provides the following (1) to (16).

(1) An insulated light-reflective substrate, comprising a substrate and an anodized film provided on a surface of the substrate, wherein:

the substrate has at its surface an aluminum alloy layer of a thickness of not less than 10 $\mu$m; the aluminum alloy layer has an aluminum purity of 99.9% by weight or higher, with a total content of Si and Fe in the layer being not more than 0.005% by weight, and a content of inevitable impurities in the layer as components other than Al, Si, Fe, Ga and Zn being not more than 0.01% by weight; the anodized film has micropores each extending from a surface of the film in a direction of thickness; and a ratio of center line length to depth (length/depth ratio) of the micropores is 1.0 to 1.2.

(2) The insulated light-reflective substrate according to (1) above, wherein the aluminum alloy layer has a Ga content of 5 to 25 ppm.
(3) The insulated light-reflective substrate according to (1) or (2) above, wherein the aluminum alloy layer has a Zn content of 5 to 20 ppm.

(4) The insulated light-reflective substrate according to any one of (1) to (3) above, whose total reflectance in visible region is 70% or higher.

(5) The insulated light-reflective substrate according to any one of (1) to (4) above, whose total reflectance for light at a wavelength of 300 to 320 nm is 70% or higher.

(6) The insulated light-reflective substrate according to any one of (1) to (5) above, which has a concaved portion for receiving a light-emitting source of a light-emitting device.

(7) The insulated light-reflective substrate according to any one of (1) to (6) above, which has surface asperities at a mean wavelength of 0.01 to 100 $\mu$m.

(8) The insulated light-reflective substrate according to any one of (1) to (7) above, wherein a surface area difference $\Delta S$ given by Equation (I):

$$\Delta S(\%) = (S_X - S_0)/S_0 \times 100 \qquad (I)$$

[where $S_x$ is an actual area of a 50 $\mu$m square region of a surface of the insulated light-reflective substrate that is determined by three-point approximation from three-dimensional data obtained by measuring the region with an atomic force microscope at $512 \times 512$ points, and So is a geometrically measured area of the region] is 1 to 50%.

(9) The insulated light-reflective substrate according to any one of (1) to (8) above, wherein:

the anodized film is provided by anodizing treatment performed under at least two different conditions;

the anodized film includes at least two different anodizing treatment layers stacked in a direction of depth between the surface of the anodized film and an interface between the aluminum alloy layer and the anodized film; and

at least one out of the anodizing treatment layers has a perpendicular depth L which is given by Equations (a) to (c):

$$L = 1/2 \times m \times \lambda \times n_{avp}/n_{avp+1} \qquad (a)$$

$$n_{avp} = n_{Al2O3} \times (1 - D_p) + n_{air} \times D_p \qquad (b)$$

$$n_{avp+1} = n_{Al2O3} \times (1 - D_{p+1}) + n_{air} \times D_{p+1} \qquad (c)$$

[where m is an integer of 1 or higher, $\lambda$ is a wavelength of light to be reflected, $n_{avp}$ is a refractive index of an anodizing treatment layer p located toward the surface of the anodized film, $n_{avp+1}$ is a refractive index of an anodizing treatment layer p+1 so located under the anodizing treatment layer p as to be in contact with the layer p, $n_{Al2O3}$ is a refractive index of aluminum oxide, $n_{air}$ is a refractive index of air which is one in value, $D_p$ is a micropore porosity of the anodizing treatment layer p, and $D_{p+1}$ is a micropore porosity of the anodizing treatment layer p+1].

(10) The insulated light-reflective substrate according to (9) above, wherein the anodized film includes two or three anodizing treatment layers different from one another in porosity, and one or two out of the anodizing treatment layers have the perpendicular depth L given by the Equations (a) to (c).

(11) The insulated light-reflective substrate according to (9) or (10) above, wherein the anodized film includes two or three anodizing treatment layers different from one another in micropore aperture diameter.

(12) The insulated light-reflective substrate according to any one of (1) to (11) above, which is a light-reflective substrate by which light emitted from a light-emitting element is reflected toward a plane through which the emitted light is to be viewed.

(13) The insulated light-reflective substrate according to any one of (1) to (12) above, further comprising a wiring layer composed of a metal conductor and provided on the surface of the anodized film, wherein the insulated light-reflective substrate is used for mounting a light-emitting element.

(14) An insulated light-reflective substrate manufacturing method for obtaining the insulated light-reflective substrate according to any one of (1) to (12) above, comprising:

a step of substrate fabrication for fabricating a substrate having at its surface an aluminum alloy layer which has an aluminum purity of 99.9% or higher, with a total content of Si and Fe in the layer being not more than 0.005% by weight, and a content of inevitable impurities in the layer as components other than Al, Si, Fe, Ga and Zn being not more than 0.01% by weight;
a step of graining treatment for subjecting a surface of the substrate to graining treatment; and
a step of anodizing treatment for subjecting the surface of the substrate after the graining treatment to anodizing treatment to form an anodized film.

(15) The insulated light-reflective substrate manufacturing method according to (14) above for obtaining the insulated light-reflective substrate according to (13) above, further comprising:

a step of wiring-layer formation following the step of anodizing treatment, for bringing metallic ink onto the anodized film by an ink-jet printing technique to form a wiring layer composed of a metal conductor.

(16) A white LED light-emitting device, comprising the insulated light-reflective substrate according to (13) above, a blue LED light-emitting element provided on the wiring layer of the insulated light-reflective substrate, and a fluorescence emitter provided around and/or over the blue LED light-emitting element.

As detailed later, according to the present invention, an insulated light-reflective substrate capable of bringing about a light-emitting device excellent in both insulation and luminous efficacy, as well as a method of manufacturing such an insulated light-reflective substrate, and a light-emitting device with such an insulated light-reflective substrate used therein are provided.

Also according to the present invention, the aluminum alloy layer composed of an aluminum alloy with a certain composition has only to be present at the surface of the substrate (as the surface layer of a thickness of at least 10 $\mu$m), so that it is possible to provide an insulated light-reflective substrate at lower cost by using a low-purity aluminum alloy, steel, or the like as a base material (hereafter also referred to as "core material") for the substrate. The present invention is thus useful.

BRIEF DESCRIPTION OF THE DRAWINGS

In the accompanying drawings:

Fig. 1 is a graph showing an exemplary waveform of alternating current used in an electrochemical graining treatment performed during a typical manufacture of the insulated light-reflective substrate of the present invention;
Fig. 2 is a schematic diagram of an example of a radial-type cell for an electrochemical graining treatment using alternating current and performed during a typical manufacture of the insulated light-reflective substrate of the present invention;
Fig. 3 is a schematic diagram of an anodizing treatment apparatus for an anodizing treatment performed during a typical manufacture of the insulated light-reflective substrate of the present invention;
Fig. 4 is a schematic diagram showing an exemplary structure of a white light-emitting device of a phosphor color mixture type;
Fig. 5A is a schematic diagram illustrating an example of a white light-emitting device with the insulated light-reflective substrate of the present invention used therein;
Fig. 5B is a schematic diagram illustrating another example of a white light-emitting device with the insulated light-reflective substrate of the present invention used therein;
Fig. 6 is a schematic cross-sectional view of an embodiment of the insulated light-reflective substrate of the present invention; and
Fig. 7 is a schematic diagram showing the concept of a brush graining process employed in a mechanical graining treatment performed during the manufacture of the insulated light-reflective substrate of the present invention.

DETAILED DESCRIPTION OF THE INVENTION

In the following, the insulated light-reflective substrate of the present invention is described in detail.

The insulated light-reflective substrate of the present invention includes a substrate having at its surface an aluminum alloy layer with a certain composition as described later, and an anodized film provided on the surface of the substrate.

The substrate is not particularly limited as long as it has at its surface the aluminum alloy layer which is not less than 10 µm thick. The substrate may be composed solely of the aluminum alloy layer, or may have the aluminum alloy layer formed on the surface of a base made of other material.

The anodized film may be prepared separately from the aluminum alloy layer, and as such adhered to the aluminum alloy layer, while it is preferable that the anodized film is integrally produced at the surface of the aluminum alloy layer by subjecting the aluminum alloy layer, from the layer surface to a specified depth, to anodizing treatment.

1. <Composition of Aluminum Alloy Layer>

The aluminum alloy layer in the insulated light-reflective substrate of the present invention has an aluminum (Al) purity of 99.9% by weight or higher, preferably of 99.99% by weight or higher, and more preferably of 99.991% by weight or higher.

In this regard, the total content of silicon (Si) and iron (Fe) as impurities in the aluminum alloy layer is not more than 0.005% by weight. Each of Si and Fe readily forms an intermetallic compound or a deposit in aluminum, and a particulate intermetallic compound or deposit in the anodized film, if any, causes breakage of insulation when voltage is loaded. Therefore, an insulated light-reflective substrate with better insulation (with a higher dielectric strength) will be obtained by keeping the total of Si and Fe contents lower. It was found as a result of investigation that, if the total of Si and Fe contents is not more than 0.005% by weight, the resultant light-reflective substrate is more excellent in insulation, while a dielectric strength of not less than 900 V, preferably of not less than 1 kV, cannot be maintained with a total of Si and Fe contents of more than 0.005% by weight. Consequently, the total of Si and Fe contents is defined as being not more than 0.005% by weight, and is preferably not more than 0.001% by weight, more preferably not more than 0.0005% by weight.

The inevitable impurities which are unavoidably included in the aluminum alloy layer during casting also affect the optical reflectance or the insulation adversely. If the total amount of the inevitable impurities is not more than 0.01% by weight, the optical reflectance is high and the insulation is good. Consequently, the total amount of the elements other than Al, Si, Fe, gallium (Ga) and zinc (Zn) that are present as inevitable impurities is defined as being not more than 0.01% by weight.

The inevitable impurities other than Si and Fe that may be included in the aluminum alloy layer are exemplified by copper (Cu), manganese (Mn), magnesium (Mg), chromium (Cr), bismuth (Bi), nickel (Ni), and titanium (Ti).

It was found as a result of investigation on trace components that adequate amounts of Ga and Zn improve the light-reflectiveness. To be more specific: It is desirable to add 5 to 25 ppm Ga by intent. Similarly, it is desirable to add 5 to 20 ppm Zn by intent. These components have the upper limits placed on their respective amounts because they also affect the dielectric strength adversely if added in larger amounts.

The phrase "aluminum alloy with a certain composition" as used herein may mean aluminum or an aluminum alloy having such a high aluminum purity as mentioned above.

2. <Substrate Having Aluminum Alloy Layer>

The substrate as a constituent element of the insulated light-reflective substrate of the present invention is not particularly limited as long as it has at its surface the aluminum alloy layer as above, which has a thickness of not less than 10 µm. The substrate may be a single-layer substrate composed solely of the aluminum alloy layer or, if necessary, a laminated substrate having the aluminum alloy layer formed on the surface of a base made of other material, such as a steel plate or other metal plate, a glass plate, a ceramic plate, and a resin plate.

The substrate of a single-layer type preferably has a thickness of about 0.1 to 5 mm.

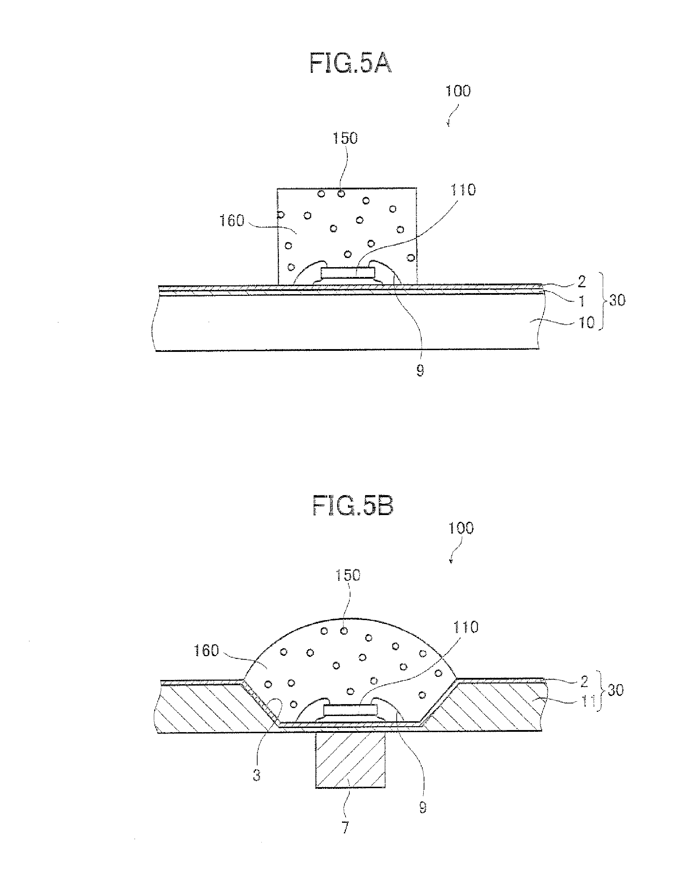

The substrate may be in the form of a flat plate, or have a concaved portion 3 for the mounting of a light-emitting element 110 as shown in Fig. 5B.

Preferably, the inner wall of the concaved portion is inclined so that the portion may open out toward the top. By virtue of such a structure, the light laterally radiated from the light-emitting element mounted on the bottom of the concaved portion can be reflected upward with efficiency.

In the case of a single-layer substrate, the anodized film to be provided on the surface of the substrate may be provided on one major face (front face) of the substrate, or on one major face and the other major face (back face) parallel to the former. The anodized film may optionally be provided on all the six faces of the substrate, namely, four end faces as well as two major faces.

The substrate of a laminated type is preferably the laminate in which the aluminum alloy layer is laminated with a steel plate or other metal plate 10 of good flexibility and high heat resistance as shown in Fig. 5A.

The laminate preferably has a thickness of about 0.1 to 5 mm, whereupon the thickness of the aluminum alloy layer is not less than 10 µm, preferably 10 to 200 µm, and more preferably 20 to 100 µm. The aluminum alloy layer may be present only on one side or on both sides of the laminate.

In the case of lamination with a steel plate, a preferred embodiment of the laminate is the molten aluminum-plated steel plate in which lamination is realized by a melt plating technique achieving an excellent adhesion between the aluminum alloy layer and the steel plate. The steel plate to be used is preferably an SUS plate (stainless steel plate).

In the case of lamination with other metal plate, specific examples of a suitable metal plate include an aluminum plate, an aluminum alloy plate, a copper plate, a nickel plate, and a titanium plate, with aluminum, aluminum alloy and nickel plates being particularly preferred. Aluminum and aluminum alloy plates allow a favorable laminate because of their chemical and physical properties approximate to those of the aluminum alloy layer with a certain composition according to the present invention. Lamination with an aluminum or aluminum alloy plate is preferably carried out by employing an aluminum-cladded material as a laminate fabricated using a brazing material.

(1) Fabrication of a molten aluminum-plated steel plate.

An exemplary method of fabricating a molten aluminum-plated steel plate is described.

A rolled stainless steel plate is prepared, and oxide film is removed from the plate surface. Oxide film may be removed in a reducing manner in the reductive annealing furnace whose interior is kept oxygen-free, or in a chemical manner by pickling.

Immediately after the removal of oxide film, the plate is immersed in an aluminum plating bath to form on the plate surface the aluminum alloy layer with a certain composition as described above. The thickness of the plating layer varies with the viscosity of molten aluminum, the surface properties of the steel plate, and so forth, and a technique for leveling the layer thickness by gas injection may be employed.

Subsequently, cooling is performed to obtain a plated steel plate. The thickness of the plating layer (aluminum alloy layer) can be controlled at will within the range from 10 $\mu$m to about 100 $\mu$m.

(2) Fabrication of an aluminum-cladded material.

An exemplary method of fabricating an aluminum-cladded material is described.

A cladding aluminum alloy and a brazing aluminum alloy are subjected to conventional casting, face milling, and heat treatment for homogenization (hereafter referred to as "soaking treatment") to prepare an ingot of cladding material and an ingot of brazing material, respectively. The cladding aluminum alloy is allowed to have the same composition as the aluminum alloy layer with a certain composition as described above. The ingots are each rolled by hot rolling to a specified thickness, so as to obtain a rolled plate of cladding material and a rolled plate of brazing material, respectively.

An aluminum alloy as a core material is also subjected to conventional casting, face milling, and soaking treatment to prepare an ingot of core material.

The ingot of core material and the rolled plate of cladding material are stacked together, with the rolled plate of brazing material being sandwiched between them, and subjected as such to heat treatment at a temperature of 450 to 550°C for at least one hour to make the materials fit with one another, then the stack is hot rolled to bond the materials together by compression so as to obtain an aluminum-cladded plate.

The aluminum-cladded plate is subjected to cold rolling and process annealing to a specified thickness, and finished by a final cold rolling so as to impart a desired thickness to the plate.

Process annealing is preferably performed at a temperature of 350 to 400°C for two to four hours. Finish annealing may also be performed in order to adjust the strength of the cladded material after the final rolling within the range of 150 to 200 MPa. In that case, annealing may be performed at a temperature of 150 to 300°C for one to three hours.

(Brazing Material)

A conventional brazing material is available for fabricating the aluminum-cladded material. Generally, an Al-Si brazing alloy containing 7 to 13% by weight Si is used. Preferred examples include JIS 4343 alloy, JIS 4045 alloy, and JIS 4047 alloy.

The brazing material begins melting at a temperature of 600°C or lower, and its liquid phase flows as a "solder" to contribute to the bonding of two aluminum materials, an upper clad material and a lower core material. As described later, the brazing material melts upon heating, and components of the brazing material in a molten form are diffused into the upper and lower aluminum materials (clad material and core material), with the depth of diffusion being not more than 10 $\mu$m. The clad as the aluminum alloy layer with a certain composition has a thickness larger than the desired thickness of the anodized film, so that the alloy components and inevitable impure components of the brazing material do not affect the aluminum alloy layer with a certain composition and, accordingly, are negligible.

(Core Material)

The core material to be used for the fabrication of an aluminum-cladded material may be a highly heat-resistant metal in plate form.

Taking special account of integral formability of a core material and a clad material constituting the surface layer, it is preferable to use an aluminum plate, an aluminum alloy plate, or a stainless steel plate as the base or core of a laminate.

If an aluminum or aluminum alloy plate is to be used, it is particularly preferable that the laminate is in the form of a cladded material with a brazing material intervening between the core and the clad.

The aluminum alloy to be used as the core material may be any of JIS 3000 series alloys or JIS 6000 series alloys, with the 6000 series alloys being preferred.

If a stainless steel plate is to be used, it is preferable that the laminate is in the form of a molten aluminum-plated steel plate having an aluminum layer formed thereon by the molten aluminum plating technique as described before.

The stainless steel plate to be used may be any known stainless steel plate. In that case, SUS 403 and SUS 304 materials are particularly preferred as plate materials.

The laminated substrate may be in the form of a flat plate, or have a concaved portion for the mounting of an element, a light-emitting element for instance, as is the case with the single-layer substrate. The concaved portion may be provided by previously processing the surface of the base onto which the aluminum alloy layer with a certain composition is to be laminated, or by processing the substrate after the lamination of the aluminum alloy layer with a certain composition. Preferably, the inner wall of the concaved portion is inclined so that the portion may open out toward the top. By virtue of such a structure, the light as laterally emitted from a light-emitting element mounted on the bottom of the concaved portion can be reflected upward with efficiency.

The laminated substrate has at its surface the aluminum alloy layer with a certain composition, over which the anodized film is provided.

3. <Physical Properties and Profile of Substrate Surface>

The insulated light-reflective substrate of the present invention preferably exhibits on its surface a total reflectance in the visible region of 70% or higher, more preferably of 80% or higher, and even more preferably of 90% or higher.

In addition, the insulated light-reflective substrate of the present invention preferably exhibits on its surface a total reflectance of 70% or higher, more preferably of 80% or higher, and even more preferably of 90% or higher for the light at a wavelength of 300 to 320 nm.

The total reflectance refers to the value as measured by a spectrophotometer. If the inventive substrate has a total reflectance in the visible region of 70% or higher, the light-emitting device of the present invention has a higher luminous efficacy, and the inventive substrate having a total reflectance of 70% or higher for the light at a wavelength of 300 to 320 nm is suitable for a next-generation system using an ultraviolet LED or the like excellent in color rendering.

Preferably, the insulated light-reflective substrate of the present invention has surface asperities at a mean wavelength of 0.01 to 100 $\mu$m allowing high values of the total reflectance. The inventive substrate may also have surface asperities at different wavelengths superimposed on one another.

With the insulated light-reflective substrate of the present invention having such surface asperities, it is expected that the light diffusing effect is improved and, at the same time, the light absorbing effect/interference inducing effect (effect possibly causing a loss in reflection) is suppressed. The insulated light-reflective substrate of the present invention is thus excellent in reflectivity.

With respect to asperities at a mean wavelength of 5 to 100 $\mu$m (hereafter also referred to as "structure with large undulation"), the mean wavelength is preferably 7 to 75 $\mu$m, more preferably 10 to 50 $\mu$m, because the light scattering effect is further increased.

With respect to asperities at a mean wavelength of 0.5 to 5 $\mu$m (hereafter also referred to as "structure with medium undulation"), the mean wavelength is preferably 0.7 to 4 $\mu$m, more preferably 1 to 3 $\mu$m, because the light scattering property is further enhanced while the light absorbing effect is restrained.

With respect to asperities at a mean wavelength of 0.01 to 0.5 $\mu$m (hereafter also referred to as "structure with small undulation"), the mean wavelength is preferably 0.015 to 0.4 $\mu$m, more preferably 0.02 to 0.3 $\mu$m, because the effect of inducing visible light interference is restrained.

The insulated light-reflective substrate of the present invention is preferably provided on its surface with at least one selected from the group consisting of the structures with large undulation, medium undulation, and small undulation as mentioned above. It is preferable from the viewpoint of further enhancing the reflectance that the surface of the inventive substrate is provided with at least two of such structures, more preferably all three of them, as superimposed on one another.

In the insulated light-reflective substrate of the present invention, the surface area difference $\Delta$S given by

Equation (I):

$$\Delta S(\%) = (S_X - S_0)/S_0 \times 100 \qquad (I)$$

[where $S_x$ is the actual area of a 50 $\mu$m square region of the surface of the insulated light-reflective substrate that is determined by three-point approximation from three-dimensional data obtained by measuring the region with an atomic force microscope at 512 $\times$ 512 points, and So is the geometrically measured area (apparent area) of the region] is preferably 1 to 50%, more preferably 3 to 20%, whereupon a surface area difference $\Delta S$ of 4 to 8% is even more preferable from the viewpoint of enhancing the white color rendering property (light scattering property) of the insulated light-reflective substrate.

The surface area difference $\Delta S$ is one of factors representing the magnitude of asperities on the surface of the insulated light-reflective substrate. A larger difference $\Delta S$ indicates that the substrate is capable of scattering light more significantly, with its optical reflectance being higher.

In the present invention, the three-dimensional data used for the calculation of the difference $\Delta S$ is obtained by measuring the surface profile with an atomic force microscope (AFM). Measurement may be carried out under the following conditions.

A 1 cm square sample is cut out from the insulated light-reflective substrate and set on a horizontal sample holder mounted on a piezoelectric scanner. A cantilever is caused to approach the surface of the sample until atomic forces were appreciable and then the surface is scanned in the X and Y directions to acquire the surface asperities of the sample based on the piezoelectric displacement in the Z direction. A piezoelectric scanner used is capable of scanning 150 $\mu$m in the X and Y directions and 10 $\mu$m in the Z direction. A cantilever having a resonance frequency of 120 to 150 kHz and a spring constant of 12 to 20 N/m (SI-DF20 manufactured by NANOPROBE Corporation) is used, with measurement being carried out in the dynamic force mode (DFM). The three-dimensional data obtained is approximated by the least-squares method to compensate for slight tilting of the sample and determine a reference plane. Measurement is performed at 512 $\times$ 512 points in a 50 $\mu$m square region of the sample surface. The resolution is 1.9 $\mu$m in the X and Y directions, and 1 nm in the Z direction. The scan rate is 60 $\mu$m/sec.

Using the three-dimensional data (f(x,y)) thus obtained, sets of adjacent three points are extracted, and the areas of minimal triangles defined by the individual sets of three points are summated, with the summation being assumed as the actual area $S_x$. The surface area difference $\Delta S$ is then calculated from the resulting actual area $S_x$ and the geometrically measured area So using Equation (I) above.

4. <Surface Treatment>

The surface treatments to be performed during the manufacture of the insulated light-reflective substrate of the present invention include various graining treatments and treatments preceding or following such graining treatments. The manufacture process for the insulated light-reflective substrate of the invention may include various treatment steps other than graining treatments and anodizing treatments.

Typical methods of imparting the surface profile as described above to the inventive substrate include the method in which the substrate having at its surface the aluminum alloy layer as described before (hereafter referred to in the "Surface Treatment" section as "aluminum plate") is subjected sequentially to alkali etching treatment, desmutting treatment with an acid, and electrochemical graining treatment in an electrolyte solution, and the method in which the aluminum plate is subjected to alkali etching treatment, desmutting treatment with an acid, and several electrochemical graining treatments in different electrolyte solutions. Mechanical graining treatment may additionally be performed before the several graining treatments.

Preferred methods for electrochemical graining treatment include those using an electrolyte solution chiefly containing nitric acid or/and hydrochloric acid. Mechanical graining treatment may or may not be performed before such a graining method.

Various processes for surface treatment are described in detail.

<Degreasing Treatment>

Degreasing treatment is aimed at removing dust, fat, resin, and so forth adhered to the surface of the aluminum plate by dissolving them in an acid, alkali, organic solvent, or the like so as to prevent the generation of defects due to organic components in the treatments as described later.

Specific examples of the method of degreasing treatment include the method in which the surface of the aluminum plate is brought into contact with an organic solvent, such as alcohol (e.g., methanol), ketone (e.g., methyl ethyl ketone), benzine and gasoline, at room temperature (organic solvent method); the method in which the surface of the aluminum plate is brought into contact with a solution containing a surfactant such as soap or neutral detergent at a temperature ranging from room temperature to 80°C, then rinsed with water (surfactant method); the method in which the surface of the aluminum plate is brought into contact with an aqueous solution of sulfuric acid at a concentration of 10 to 200 g/L at a temperature ranging from room temperature to 70°C for 30 to 80 seconds, then rinsed with water; the method in which the surface of the aluminum plate is subjected to electrolysis by bringing the surface into contact with an aqueous solution of sodium hydroxide at a concentration of 5 to 20 g/L at room temperature for about 30 seconds, and using the surface in contact with the solution as a cathode to pass a direct current at a current density of 1 to 10 $A/dm^2$, then neutralized with an aqueous solution of nitric acid at a concentration of 100 to 500 g/L brought into contact with the surface; the method in which the surface of the aluminum plate is subjected to electrolysis by bringing the surface into contact with any of various known electrolyte solutions for anodizing treatment at room temperature, and using the surface in contact with the solution as a cathode to pass a direct current at a current density of 1 to 10 $A/dm^2$, or alternating current; the method in which the surface of the aluminum plate is brought into contact with an aqueous alkaline solution at a concentration of 10 to 200 g/L at 40 to 50°C for 15 to 60 seconds, then neutralized with an aqueous solution of nitric acid at a concentration of 100 to 500 g/L brought into contact with the surface; the method in which the surface of the aluminum plate is brought into contact with an emulsion prepared by mixing light oil, kerosene or the like with a surfactant, water or the like at a temperature ranging from room temperature to 50°C, then rinsed with water (emulsion method); and the method in which the surface of the aluminum plate is brought into contact with a liquid mixture of sodium carbonate, a phosphate salt and a surfactant, for instance, at a temperature ranging from room temperature to 50°C for 30 to 180 seconds, then rinsed with water (phosphate method).

Among the above, the organic solvent method, the surfactant method, the emulsion method, and the phosphate method are preferable because they not only allow removal of fats on the surface of the aluminum plate but seldom cause aluminum to be dissolved.

A conventional degreasing agent may be used for degreasing treatment. Specifically, degreasing treatment may be performed by using any of a variety of commercially available degreasing agents in a specified manner.

<Mechanical Graining Treatment>

Mechanical graining treatment can realize a surface asperities at a mean wavelength of 5 to 100 $\mu$m at lower cost than electrochemical graining treatment, so that it is useful as a means for the graining treatment forming a structure with large undulation.

Examples of the method to be used for mechanical graining treatment include the wire brush graining method in which the surface of the aluminum plate is scratched by metal wires; the ball graining method in which the surface of the aluminum plate is grained with abrading balls and an abrasive; and the brush graining methods as described in JP 6-135175 A and JP 50-40047 B in each of which the plate surface is grained with nylon brushes and an abrasive.

It is also possible to employ the transferring method in which the surface with asperities is pressed onto the aluminum plate. Apart from the methods as described in JP 55-74898 A, JP 60-36195 A, and JP 60-203496 A, the method of JP 6-55871 A which is characterized in that transferring is performed several times, and the method of JP 6-24168 A which is characterized in that the surface to be treated is flexible in nature are available.

The method in which transferring is repeated by using a transfer roll with fine asperities etched on its surface by electrical discharge machining, shot blasting, laser etching, plasma etching, or the like, or the method in which a surface with asperities provided by applying finely-divided particles thereto is brought into contact with the surface of the aluminum plate, and pressed against the plate surface several times so as to transfer the pattern of the asperities to the aluminum plate several times in a repeated manner, with the mean diameter of the asperities thus formed on the plate being corresponding to that of the particles, may also be employed. Examples of the method to be used to impart fine asperities to a transfer roll include the known methods as described in JP 3-8635 A, JP 3-66404 A, and JP 63-65017 A. It is also possible to cut fine grooves in the roll surface in two directions using a die, a cutting tool, a laser or the like to impart square asperities to the surface. In that case, the roll surface with square asperities may be subjected to a known etching treatment so as to make its asperities rounded.

Quenching or hard chromium plating may be performed in order to increase the surface hardness.

In addition, the methods as described in JP 61-162351 A and JP 63-104889 A are usable as a method for mechanical graining treatment.

In the present invention, two or more of the methods as described above may be employed in combination taking account of productivity. Any of the above methods for mechanical graining treatment is preferably practiced before electrochemical graining treatment.

A brush graining method suitable for mechanical graining treatment is described below.

In a general brush graining method, the surface of the aluminum plate as described before is rubbed on one or both sides of the plate with the rotating roller brushes onto which a slurry containing an abrasive is being sprayed. A roller brush used has the cylindrical body in which multiple brush bristles, including bristles made of a synthetic resin such as nylon (trademark), polypropylene and polyvinyl chloride, are set. The roller brushes and the slurry may be replaced by abrading rollers each having an abrasive layer provided on its surface. If a roller brush is to be used, its bristles preferably have a flexural modulus of 10,000 to 40,000 kgf/cm$^2$, more preferably of 15,000 to 35,000 kgf/cm$^2$, and their stiffness is preferably up to 500 gf, more preferably up to 400 gf. The diameter of the brush bristles is generally 0.2 to 0.9 mm, and their length, which may be chosen as appropriate to the outer diameter of the roller brush and the diameter of the brush body, is generally 10 to 100 mm.

The abrasive may be a known one. Examples of the abrasive which may be used include such abrasives as pumice stone, silica sand, aluminum hydroxide, alumina powder, silicon carbide, silicon nitride, volcanic ash, carborundum, and emery; as well as mixtures thereof. Among others, pumice stone and silica sand are preferable. Silica sand is particularly preferred because it is harder and less breakable than pumice stone, and excellent in graining efficiency accordingly. The mean particle size of the abrasive is preferably 3 to 50 $\mu$m, more preferably 6 to 45 $\mu$m. Such a mean particle size allows a high graining efficiency and a suitably small graining pitch. The abrasive is used as a slurry prepared by suspending it in water, for instance. The slurry may contain apart from the abrasive a thickening agent, a dispersant (e.g., surfactant), a preservative, and so forth. The specific gravity of the slurry is preferably 0.5 to 2.

The apparatus which is suitable for mechanical graining treatment may be exemplified by the apparatus as described in JP 50-40047 B.

<Electrochemical Graining Treatment>

For electrochemical graining treatment (hereafter also referred to as "electrolytic graining treatment"), an electrolyte solution for the conventional electrochemical graining treatment using alternating current is usable. An electrolyte solution chiefly containing hydrochloric acid or nitric acid is particularly preferred because the surface profile as described before is readily achievable by the use of such a solution.

Electrolytic graining treatment may follow the electrochemical graining method (electrolytic graining method) as described in JP 48-28123 B or GB 896,563, for example. While such electrolytic graining methods use an alternating current with a sinusoidal waveform, a special waveform such as described in JP 52-58602 A will also do. The waveform as described in JP 3-79799 A may also be used. In addition, the methods as described in JP 55-158298 A, JP 56-28898 A, JP 52-58602 A, JP 52-152302 A, JP 54-85802 A, JP 60-190392 A, JP 58-120531 A, JP 63-176187 A, JP 1-5889 A, JP 1-280590 A, JP 1-118489 A, JP 1-148592 A, JP 1-178496 A, JP 1-188315 A, JP 1-154797 A, JP 2-235794 A, JP 3-260100 A, JP 3-253600 A, JP 4-72079 A, JP 4-72098 A, JP 3-267400 A and JP 1-141094 A are applicable. Besides the aforementioned, it is also possible to perform the electrolysis using an alternating current with a special frequency which has been proposed as a method of producing an electrolytic capacitor. It is described for example in US 4,276,129 and US 4,676,879.

Various electrolytic cells and power supplies have been proposed for use in electrolytic treatment. For example, use may be made of those described in US 4,203,637, JP 56-123400 A, JP 57-59770 A, JP 53-12738 A, JP 53-32821 A, JP 53-32822 A, JP 53-32823 A, JP 55-122896 A, JP 55-132884 A, JP 62-127500 A, JP 1-52100 A, JP 1-52098 A, JP 60-67700 A, JP 1-230800 A, JP 3-257199 A, JP 52-58602 A, JP 52-152302 A, JP 53-12738 A, JP 53-12739 A, JP 53-32821 A, JP 53-32822 A, JP 53-32833 A, JP 53-32824 A, JP 53-32825 A, JP 54-85802 A, JP 55-122896 A, JP 55-132884 A, JP 48-28123 B, JP 51-7081 B, JP 52-133838 A, JP 52-133840 A, JP 52-133844 A, JP 52-133845 A, JP 53-149135 A and JP 54-146234 A.

The electrolyte solutions as described in US 4,671,859, US 4,661,219, US 4,618,405, US 4,600,482, US 4,566,960, US 4,566,958, US 4,566,959, US 4,416,972, US 4,374,710, US 4,336,113 and US 4,184,932 are available apart from nitric acid and hydrochloric acid as the acidic electrolyte solution to be used.

The concentration of the acidic electrolyte solution is preferably 0.5 to 2.5% by weight, with a concentration of 0.7 to 2.0% by weight being particularly preferred taking account of the fact that the acidic solution is also used for the desmutting treatment as mentioned before. The solution temperature is preferably 20 to 80°C, more preferably 30 to 60°C.

The electrolyte solution chiefly containing hydrochloric acid or nitric acid may be a 1-100 g/L aqueous solution of hydrochloric acid or nitric acid having at least one out of nitric acid ion-containing compounds such as aluminum nitrate, sodium nitrate and ammonium nitrate or hydrochloric acid ion-containing compounds such as aluminum chloride, sodium chloride and ammonium chloride added thereto in an amount ranging from 1 g/L to a saturating amount. In the aqueous solution chiefly containing hydrochloric acid or nitric acid, an aluminum alloy component, such as iron, copper, manganese, nickel, titanium, magnesium and silica, may also be dissolved. Preferably, aluminum chloride, aluminum nitrate or the like is added to a 0.5-2 wt% aqueous solution of hydrochloric acid or nitric acid so that the aluminum ion concentration may be 3 to 50 g/L.

The electrolyte solution to which a compound capable of forming a complex with Cu is further added allows uniform graining even if the aluminum plate contains Cu in large amounts. Examples of the compound capable of forming a complex with Cu include ammonia; amines obtained by substituting the hydrogen atom on ammonia with a hydrocarbon group (of an aliphatic, aromatic, or other nature), such as methylamine, ethylamine, dimethylamine, diethylamine, trimethylamine, cyclohexylamine, triethanolamine, triisopropanolamine and ethylenediamine tetraacetate (EDTA); and metal carbonates such as sodium carbonate, potassium carbonate and potassium hydrogencarbonate. Further included are ammonium salts such as ammonium nitrate, ammonium chloride, ammonium sulfate, ammonium phosphate and ammonium carbonate. The solution temperature is preferably 10 to 60°C, and more preferably 20 to 50°C.

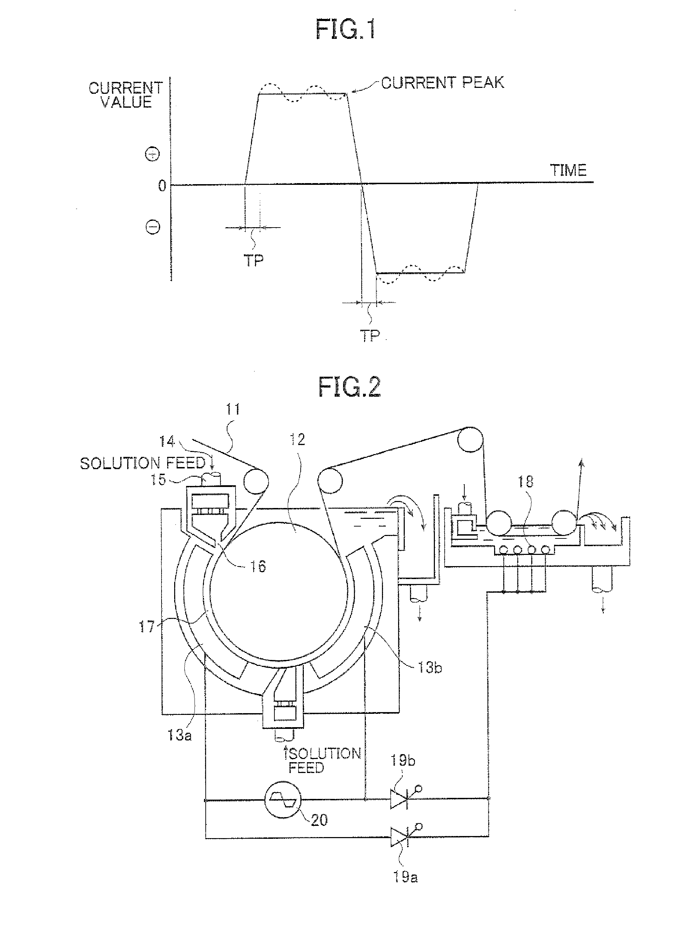

No particular limitation is imposed on the AC power supply waves used for electrochemical graining treatment. For example, sinusoidal, square, trapezoidal or triangular waves may be used. Preferred are square or trapezoidal waves, with trapezoidal ones being especially preferred. "Trapezoidal" waves are waves having such a waveform as shown in Fig. 1. In the trapezoidal waveform, the time (TP) in which the current value changes from zero to a peak is preferably 1 to 3 msec. If the time TP is less than 1 msec, chatter marks indicative of treatment unevenness extending perpendicularly to the direction in which the aluminum plate advances are liable to occur. If the time TP is more than 3 msec, graining treatment is more susceptible to the trace components in the electrolyte solution that may be typified by ammonium ions spontaneously increased during an electrolytic treatment particularly when a nitric acid-containing electrolyte solution is used, which makes a uniform graining hard to achieve.

A trapezoidal wave alternating current with a duty ratio ranging from 1:2 to 2:1 is usable, and the duty ratio is preferably 1:1 in such an indirect power supplying system dispensing with a conductor roll for aluminum as described in JP 5-195300 A. While a trapezoidal wave alternating current at a frequency of 0.1 to 120 Hz is usable, the frequency is preferably 50 to 70 Hz in terms of equipment. If the frequency is lower than 50 Hz, the carbon electrode as a principal electrode is liable to be dissolved, and a frequency higher than 70 Hz will make inductance components on a power supply circuit more influential, resulting in the increase in electric power cost.

One or more AC power supplies may be connected to the electrolytic cell. To control the anode/cathode current ratio of the alternating current applied to the aluminum plate opposite a principal electrode and thereby carry out uniform graining, and to dissolve carbon from the principal electrode, it is advantageous to provide an auxiliary anode 18 and shunt some of the alternating current as is shown in Fig. 2. Fig. 2 shows an aluminum plate 11, a radial drum roller 12, principal electrodes 13a and 13b, an electrolytic treatment solution 14, a solution feed inlet 15, a slit 16, a solution channel 17, the auxiliary anode 18, thyristors 19a and 19b, an AC power supply 20, a major electrolytic cell 40, and an auxiliary anode cell 50. By using a rectifying or switching device to shunt some of the current as direct current to the auxiliary anode provided in the cell separated from that containing the two principal electrodes, it is possible to control the ratio between the values of the current used for the anodic reaction on the aluminum plate opposite the principal electrodes and the current used for the cathodic reaction on the aluminum plate. The ratio between the amount of electricity used for the anodic reaction and that used for the cathodic reaction, with both reactions occurring on the aluminum plate opposite the principal electrodes, (ratio of the amount of electricity when the aluminum plate serves as a cathode to the amount of electricity when the aluminum plate serves as an anode) is preferably 0.3 to 0.95.

Any known electrolytic cell employed for surface treatment, including vertical, flat and radial type electrolytic cells, may be used in the present invention. Radial-type electrolytic cells such as described in JP 5-195300 A are especially preferred. The electrolyte solution passes through the electrolytic cell either parallel or counter to the direction in which the aluminum web advances.

(Nitric Acid Electrolysis)

Electrochemical graining treatment with an electrolyte solution chiefly containing nitric acid allows asperities at a mean wavelength of 0.5 to 5 $\mu$m. Asperities, however, may be generated at a wavelength over 5 $\mu$m due to the localization of electrolytic reaction if the amount of electricity is relatively high.

In order to achieve a surface profile with asperities at a mean wavelength of 0.5 to 5 $\mu$m, the total amount of electricity used for the anodic reaction on the aluminum plate is preferably 1 to 1000 C/dm$^2$, more preferably 50 to 300 C/dm$^2$, at the end of electrolytic reaction. In this regard, the current density is preferably 20 to 100 A/dm$^2$.

A structure with small undulation at a mean wavelength of not more than 0.20 $\mu$m may be formed by electrolysis at a temperature of 30 to 60°C using a nitric acid-containing electrolyte solution of high concentration having a nitric acid concentration of 15 to 35% by weight, for instance, or electrolysis at a high temperature of not less than 80°C, for instance, using a nitric acid-containing electrolyte solution at a nitric acid concentration of 0.7 to 2% by weight. As a consequence, the difference $\Delta S$ calculated with Equation (I) as above can be increased.

(Hydrochloric Acid Electrolysis)

Since hydrochloric acid in itself has a high aluminum-dissolving power, fine asperities can be formed on the plate surface only by applying a small current. Such fine asperities have a mean wavelength of 0.01 to 0.2 $\mu$m, and are generated uniformly on the entire surface of the aluminum plate.

In order to achieve a surface profile with such asperities as above, the total amount of electricity used for the anodic reaction on the aluminum plate is preferably 1 to 100 $C/dm^2$, more preferably 20 to 70 $C/dm^2$, at the end of electrolytic reaction. In this regard, the current density is preferably 20 to 50 $A/dm^2$.

During the electrochemical graining treatment with an electrolyte solution chiefly containing hydrochloric acid that is performed under the above conditions, a large undulation in crater form may be formed concurrently with fine asperities by increasing the total amount of electricity used for the anodic reaction to 400 to 2000 $C/dm^2$. In that case, fine asperities at a mean wavelength of 0.01 to 0.4 $\mu$m are generated on the entire surface as being superimposed on a large undulation in crater form at a mean wavelength of 10 to 30 $\mu$m, while a structure with medium undulation at a mean wavelength of 0.5 to 5 $\mu$m is not formed.

It is effective at increasing the difference $\Delta S$ to provide the plate surface with many small recesses or protrusions. Suitable methods of providing the plate surface with such recesses or protrusions include an electrolytic graining treatment with an electrolyte solution chiefly containing hydrochloric acid, and an electrolytic graining treatment with a high-concentration and high-temperature electrolyte solution chiefly containing nitric acid. The increase in difference $\Delta S$ is also possible indeed by mechanical graining treatment or an electrolytic graining treatment with an ordinary electrolyte solution chiefly containing nitric acid, although to a small extent.

It is preferable that the aluminum plate is subjected to cathodic electrolysis treatment before and/or after the above electrolytic graining treatment performed in an electrolyte solution such as a hydrochloric acid solution or a nitric acid solution. Cathodic electrolysis produces smut on the surface of the aluminum plate and, at the same time, generates hydrogen gas, allowing the electrolytic graining treatment to be carried out more uniformly.

Cathodic electrolysis treatment is performed in an acidic solution, whereupon the amount of electricity at cathode is preferably 3 to 80 $C/dm^2$, and more preferably 5 to 30 $C/dm^2$. Adhesion of smut may be inadequate with an amount of electricity at cathode under 3 $C/dm^2$, while in excess with an amount of electricity at cathode over 80 $C/dm^2$. The electrolyte solution to be used for cathodic electrolysis treatment may or may not be identical to that for the electrolytic graining treatment.

<Alkali Etching Treatment>

In alkali etching treatment, the surface layer of the aluminum plate as described before is dissolved by bringing the aluminum plate into contact with an alkaline solution.

The purpose of the alkali etching treatment to be performed prior to the electrolytic graining treatment is to remove rolling oil, soil, natural oxide film, and so forth from the surface of the aluminum plate (rolled aluminum plate) if the mechanical graining treatment has not been performed, or to dissolve the edges of the asperities as formed by the mechanical graining treatment so as to make the plate surface have a gentle undulation instead of sharp asperities if the mechanical graining treatment has already been performed.

In the case where no mechanical graining treatment is to be performed before alkali etching treatment, the etching amount is preferably 0.1 to 10 $g/m^2$, and more preferably 1 to 5 $g/m^2$. If the etching amount is less than 0.1 $g/m^2$, rolling oil, soil, natural oxide film, and so forth may remain on the plate surface and, in that case, asperities formed by the subsequent electrolytic graining treatment may not be uniform, that is to say, asperities may be formed with unevenness. On the other hand, an etching amount within the range of 1 to 10 $g/m^2$ allows an adequate removal of rolling oil, soil, natural oxide film, and so forth from the plate surface. It is economically disadvantageous to choose an etching amount beyond the above range.

In the case where the mechanical graining treatment is to be performed before alkali etching treatment, the etching amount is preferably 3 to 20 $g/m^2$, and more preferably 5 to 15 $g/m^2$. If the etching amount is less than 3 $g/m^2$, the asperities as formed by the mechanical graining treatment may not be smoothed and, in that case, asperities formed by the subsequent electrolytic graining treatment may not be uniform. The etching amount is more than 20 $g/m^2$, asperities may be no more present.

The purpose of the alkali etching treatment to be performed immediately after the electrolytic graining treatment is to dissolve the smut generated in an acidic electrolyte solution, and the edges of the asperities as formed by the electrolytic graining treatment, as well. While asperities formed by the electrolytic graining treatment vary with the type of electrolyte solution, and the optimal etching amount for them varies accordingly, the etching amount is preferably 0.1 to 5 $g/m^2$ in the alkali etching treatment performed after the electrolytic graining treatment. The etching amount in a treatment with a nitric acid-containing electrolyte solution needs to be made higher than that in a treatment with a hydrochloric acid-containing electrolyte solution. If the electrolytic graining treatment should be performed several times, alkali etching treatment may be performed after each treatment as required.

The alkali to be used in the alkaline solution is exemplified by caustic alkalis and alkali metal salts. Specific examples of suitable caustic alkalis include sodium hydroxide and potassium hydroxide. Specific examples of suitable alkali metal salts include alkali metal silicates such as sodium metasilicate, sodium silicate, potassium metasilicate and potassium silicate; alkali metal carbonates such as sodium carbonate and potassium carbonate; alkali metal aluminates such as sodium aluminate and potassium aluminate; alkali metal aldonates such as sodium gluconate and potassium gluconate; and alkali metal hydrogenphosphates such as sodium secondary phosphate, potassium secondary phosphate, sodium primary phosphate and potassium primary phosphate. Among others, caustic alkali solutions and solutions containing both a caustic alkali and an alkali metal aluminate are preferred on account of their high etch rates and low costs. An aqueous solution of sodium hydroxide is especially preferred.

The concentration of the alkaline solution may be selected in accordance with the etching amount, while the concentration is preferably 1 to 50% by weight, and more preferably 10 to 35% by weight. If aluminum ions are present in the alkaline solution, the aluminum ion concentration is preferably 0.01 to 10% by weight, and more preferably 3 to 8% by weight. Preferred temperatures of the alkaline solution fall within the range of 20 to 90°C. The treatment time is preferably 1 to 120 seconds.

Examples of the method of bringing the aluminum plate into contact with an alkaline solution include the method in which the aluminum plate is passed through a tank filled with an alkaline solution, the method in which the aluminum plate is immersed in an alkaline solution contained in a tank, and the method in which the surface of the aluminum plate is sprayed with an alkaline solution.

<Desmutting Treatment>

It is preferable that pickling (desmutting treatment) is performed after the electrolytic graining treatment or the alkali etching treatment so as to remove soil (smut) remaining on the plate surface.

Examples of the acid to be used include nitric acid, sulfuric acid, phosphoric acid, chromic acid, hydrofluoric acid, and fluoroboric acid. Desmutting treatment is performed by, for instance, bringing the aluminum plate as described before into contact with an acidic solution containing 0.5 to 30% by weight hydrochloric acid, nitric acid, sulfuric acid or the like (and 0.01 to 5% by weight aluminum ions as well). Examples of the method of bringing the aluminum plate into contact with an acidic solution include the method in which the aluminum plate is passed through a tank filled with an acidic solution, the method in which the aluminum plate is immersed in an acidic solution contained in a tank, and the method in which the surface of the aluminum plate is sprayed with an acidic solution. The acidic solution to be used for desmutting treatment may be the aqueous solution chiefly containing nitric acid or hydrochloric acid that has been used for the electrolytic graining treatment as above and then discharged as a waste liquid, or the aqueous solution chiefly containing sulfuric acid that has been used for the anodizing treatment as described later and then discharged as a waste liquid. During the desmutting treatment, the solution temperature is preferably 25 to 90°C. The treatment time is preferably 1 to 180 seconds. The acidic solution to be used for desmutting treatment may have aluminum and aluminum alloy components dissolved therein.

5. <Through Hole Processing and Routing Processing>

If a light-emitting element is to be mounted on the insulated light-reflective substrate of the present invention, the substrate may be subjected to through hole processing in order to provide appropriate wiring, and routing processing in order to make chips adapted for final products. Through hole processing may be performed before or after the surface treatment or the anodizing treatment. If such processings as above are performed before an insulating layer is formed by the anodization as described later, cracks are prevented from appearing in the insulating layer formed by anodization, and the substrate end faces resulting from the processings are kept insulated. If the processings are performed after the anodizing treatment, the anodization efficiency is increased, and the substrate is precisely processed with dimensions corresponding to those of the final product.

Suitable methods for through hole processing and for routing processing are exemplified by drilling, die stamping, dicing on a dicing instrument, and laser processing, although not limited thereto.

6. <Anodizing Treatment>

The aluminum plate as subjected to the surface treatment, and processed if necessary, is further subjected to anodizing treatment. By anodizing treatment, an anodized film composed of aluminum oxide is formed over the aluminum plate as a porous or nonporous insulating surface layer. Anodizing treatment may be performed as required not only on a major face of the aluminum plate but the inside of a through hole or an end face of the aluminum plate so as to make them insulated and light-reflective.

Anodizing treatment may be carried out in a conventional manner. The solution to be used for anodizing treatment may include any one or any combination of two or more out of sulfuric acid, phosphoric acid, chromic acid, oxalic acid, sulfamic acid, benzenesulfonic acid, amidosulfonic acid, malonic acid, citric acid, tartaric, and boric acid, and an alkali metal/alkaline-earth metal hydroxide, such as sodium hydroxide, magnesium hydroxide, potassium hydroxide and calcium hydroxide.

If anodizing treatment conditions should be controlled so that the anodized film may have straight-cylindrical micropores, the self-ordering method or the constant voltage treatment as described in paragraphs [0055] to [0108] of JP 2008-270158 A may be employed.

In this connection, it is acceptable that components ordinarily present in at least the aluminum plate, electrodes, tap water, ground water, and the like are contained in an electrolyte solution. It is also acceptable that secondary and tertiary components are added to the solution. Examples of the "secondary and tertiary components" include ions of such a metal as Na, K, Ma, Li, Ca, Ti, Al, V, Cr, Mn, Fe, Co, Ni, Cu and Zn; cations such as ammonium ions; and anions such as nitrate ions, carbonate ions, chloride ions, phosphate ions, fluoride ions, sulfite ions, titanate ions, silicate ions and borate ions. These may be present in a concentration of 0 to about 10,000 ppm.

The anodizing treatment conditions vary empirically according to the electrolyte solution used, although it is generally suitable for the electrolyte solution to have a concentration of 1 to 80% by weight and a temperature of 5 to 70°C, and for the current density to be 0.5 to 60 A/dm$^2$, the voltage to be 1 to 600 V, and for the electrolysis time to be 15 seconds to 20 hours. These conditions are adjusted to achieve the desired anodized film weight.

Methods that may be used to carry out anodizing treatment include those described in JP 54-81133 A, JP 57-47894 A, JP 57-51289 A, JP 57-51290 A, JP 57-54300 A, JP 57-136596 A, JP 58-107498 A, JP 60-200256 A, JP 62-136596 A, JP 63-176494 A, JP 4-176897 A, JP 4-280997 A, JP 6-207299 A, JP 5-24377 A, JP 5-32083 A, JP 5-125597 A, and JP 5-195291 A.

Among others, it is preferable to use a sulfuric acid solution as the electrolyte solution, as described in JP 54-12853 A and JP 48-45303 A. The solution has a sulfuric acid concentration of preferably 10 to 300 g/L, more preferably 10 to 100 g/L, and an aluminum ion concentration of preferably 1 to 25 g/L, more preferably 2 to 10 g/L. Such an electrolyte solution can be prepared by, for instance, adding aluminum sulfate to a dilute sulfuric acid having a sulfuric acid concentration of 50 to 200 g/L.

In the case where anodizing treatment is to be performed in an electrolyte solution containing sulfuric acid, either of direct current and alternating current, or alternating current definitely may be applied across the aluminum plate and the counter electrode. If direct current is applied to the aluminum plate, it is desirable to apply a constant voltage across the aluminum plate and the counter electrode, with a voltage of 10 to 50 V being preferred.

The anodized film of the invention has micropores each extending from the film surface in the direction of film thickness, whereupon the ratio of center line length to depth (length/depth ratio) of the micropores is 1.0 to 1.2, preferably 1.0 to 1.1, and more preferably 1.0 to 1.05. The micropores whose shape is such that the above ratio falls within the above range allow the insulated light-reflective substrate to be excellent in both insulation and optical reflectance.

The anodized film which is porous has a mean micropore diameter of about 5 to 1000 nm, and a mean micropore density of about $1 \times 10^6$ to $1 \times 10^{10}$ pores/mm$^2$.

The anodized film preferably has a thickness of 1 to 200 $\mu$m. A thickness under 1 $\mu$m makes the film less insulating, that is to say, reduced in dielectric strength, while that over 200 $\mu$m is economically disadvantageous because electric power required for manufactured is considerably increased. The thickness of the anodized film is more preferably 2 to 100 $\mu$m, and even more preferably 20 to 70 $\mu$m.

Preferably, the anodized film is provided by an anodizing treatment performed under at least two different conditions, and includes as such at least two different anodizing treatment layers stacked in the direction of depth between the film surface and the interface between the aluminum alloy layer as described before and the anodized film, whereupon at least one anodizing treatment layer has the perpendicular depth L which is given by Equations (a) to (c):

$$L = 1/2 \times m \times \lambda \times n_{avp}/n_{avp+1} \qquad (a)$$

$$n_{avp} = n_{Al2O3} \times (1 - D_p) + n_{air} \times D_p \qquad (b)$$

$$n_{avp+1} = n_{Al2O3} \times (1 - D_{p+1}) + n_{air} \times D_{p+1} \qquad (c)$$

[where m is an integer of 1 or higher, $\lambda$ is the wavelength of light to be reflected, $n_{avp}$ is the refractive index of an anodizing treatment layer p located toward the surface of the anodized film, $n_{avp+1}$ is the refractive index of an anodizing treatment layer p+1 so located under the anodizing treatment layer p as to be in contact with the layer p, $n_{Al2O3}$ is the refractive index of aluminum oxide, $n_{air}$ is the refractive index of air which is one in value, $D_p$ is the micropore porosity of the anodizing treatment layer p, and $D_{p+1}$ is the micropore porosity of the anodizing treatment layer p+1].

As an example, discussion is made on the case where an anodizing treatment layer 1 obtained by a first anodizing treatment has holes as portions corresponding to the micropores at a porosity of 0.33 (33%), and an anodizing treatment layer 2 obtained by a second anodizing treatment has holes at a porosity of 0 (0%), and the perpendicular depth L given by the above equations.

Assuming that the anodizing treatment layer 1 is located toward the surface of the anodized film, and the anodizing treatment layer 2 is under the layer 1, and that the refractive index of alumina is 1.6, the following are calculated.

$$n_{av1} = 1.6 \times (1 - 0.33) + 1 \times 0.33 = 1.4$$

$$n_{av2} = 1.6 \times (1 - 0) + 1 \times 0 = 1.6$$

$$n_{av1}/ \ n_{av2} = 1.4/1.6$$

If light at a wavelength of 450 nm enters the anodizing treatment layers 1 and 2, the relation of Equation (a) will be satisfied when the waveform of light B so reflected from the bottom section of the anodizing treatment layer 2 as to travel along an optical path 2L long and the waveform of light A reflected from the bottom section of the anodizing treatment layer 1 are coincident with each other, leading to the amplification of reflection.

Equation (a) is written accordingly as:

$$L = 1/2 \times m \times 450 \times 1.4/1.6,$$

and reflection is amplified with a depth L of 197 nm if m is 1, or with a depth L of 394 nm if m is 2.

In the case where an anodizing treatment layer 1 obtained by a first anodizing treatment has holes at a porosity of 0.33 (33%), an anodizing treatment layer 2 obtained by a second anodizing treatment has holes at a porosity of 0.42 (42%), and the perpendicular depth L given by the above equations, and an anodizing treatment layer 3 obtained by a third anodizing treatment has holes at a porosity of 0.33 (33%), the following are calculated assuming that the anodizing treatment layer 1 is located toward the surface of the anodized film, and the anodizing treatment layers 2 and 3 are under the layer 1 in this order, and that the refractive index of alumina is 1.6.

$$n_{av1} = 1.6 \times (1 - 0.33) + 1 \times 0.33 = 1.4$$

$$n_{av2} = 1.6 \times (1 - 0.42) + 1 \times 0.42 = 1.35$$

$$n_{av3} = 1.6 \times (1 - 0.33) + 1 \times 0.33 = 1.4$$

$$n_{av2}/ \ n_{av3} = 1.35/1.4$$

If light at a wavelength of 450 nm enters the holes of the anodizing treatment layers 2 and 3 through the holes of the anodizing treatment layer 1, the relation of Equation (a) will be satisfied when the waveform of light B so reflected from the bottom section of the anodizing treatment layer 3 as to travel along an optical path 2L long and the waveform of light A reflected from the bottom section of the anodizing treatment layer 2 are coincident with each other, leading to the amplification of reflection.

Equation (a) is written accordingly as:

$$L = 1/2 \times m \times 450 \times 1.35/1.4,$$

and reflection is amplified with a depth L of 216 nm if m is 1, or with a depth L of 433 nm if m is 2.

In the case of the anodized film including two different anodizing treatment layers in total, for instance, reflection of the light at a wavelength λ to be reflected is considered to be amplified by the interference to resonance of light reflected from the bottom section of the anodizing treatment layer 1 as obtained by the first anodizing treatment and light reflected from the bottom section of the anodizing treatment layer 2 as obtained by the second anodizing treatment with each other if the anodizing treatment layer 2 communicating with the anodizing treatment layer 1 has the perpendicular depth L given by the above Equation (a), although the mechanism of the amplification of reflection is in no way limited to such.

Depending on the anodizing treatment conditions, micropores may be formed with the mean aperture diameter specified, or with no mean aperture diameter specified due to a random production of alumina, aluminum hydroxide, or a hydrate of the oxide or hydroxide with voids. In the present invention, portions corresponding to such micropores are referred to as "holes."

The inventors of the present invention found that, even if holes are formed with no mean aperture diameter as specified, reflection of the light at a wavelength λ to be reflected is amplified by the interference of light reflected from the bottoms of the holes of the anodizing treatment layer 1 as obtained by the first anodizing treatment and light reflected from the bottoms of the holes of the anodizing treatment layer 2 as obtained by the second anodizing treatment with each other if the holes of at least one anodizing treatment layer have the perpendicular depth L which is given by Equation (a).

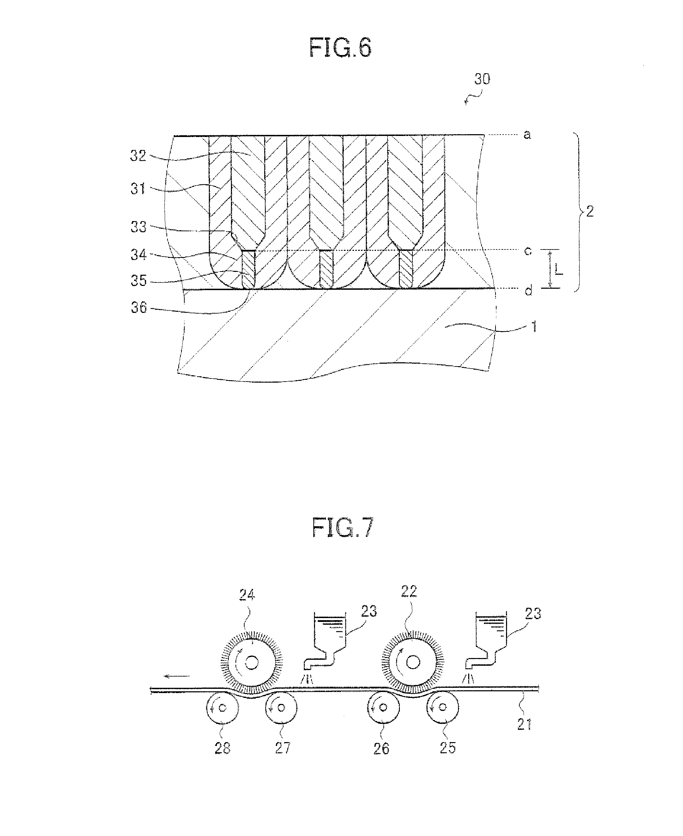

The anodizing treatment layers are not limited in shape by their forming method, with a characteristic example being shown in Fig. 6. The anodizing treatment layers of Fig. 6 are formed by the method in which an anodizing treatment layer with a high porosity is formed by a first anodizing treatment, then the holes of the layer as formed that correspond to micropores are reduced in aperture diameter, or filled in with a porous form of the layer being kept intact, by a second anodizing treatment.

Fig. 6 is a schematic cross-sectional view of an embodiment of the insulated light-reflective substrate of the present invention which has an aluminum alloy layer provided with an anodized film.

An insulated light-reflective substrate 30 shown in the figure has the laminated structure in which an anodized aluminum film 2 is laminated onto an aluminum alloy layer 1. The level of the surface of the anodized film 2 is indicated by a dotted line a, while the level of the interface between the aluminum alloy layer 1 and the anodized film 2 is indicated by a dotted line d.

An anodizing treatment layer p formed by a first anodizing treatment, which is shown with the numeral 31, has holes 32 corresponding to micropores, each extending from the surface of the layer p as indicated by the line a toward the aluminum alloy layer 1, and a bottom section 33. The position of the bottom section 33 is indicated by a dotted line c. An anodizing treatment layer p+1 formed by a second anodizing treatment, which is shown with the numeral 34, has holes 35 corresponding to micropores, and a bottom section 36. The anodizing treatment layers p and p+1 are formed by the first and second anodizing treatments different from each other to have the holes 32 and 35, respectively, at different porosities, Dp and Dp+1. The anodizing treatment layers p and p+1 are communicating with each other through the bottom section 33, and the bottom section 36 of the anodizing treatment layer p+1 is located on the line d indicating the level of the interface between the aluminum alloy layer 1 and the anodized film 2. The perpendicular depth L of the anodizing treatment layer p+1 is represented by the distance between the lines c and d. The term "communicating" as used herein means a state allowing fluids (gas and liquid) to flow through.

The perpendicular depth (also referred to as "thickness") of the anodizing treatment layer p or p+1 is found by photographing a cross section of the anodized film 2 as shown in Fig. 6 (with a magnification of 150,000×), measuring at least 25 holes of the anodizing treatment layer in depth, and averaging the measured values.

<Sealing Treatment>

In the present invention, sealing treatment for sealing micropores may be performed as required on the anodized film which is porous. Sealing treatment may be carried out by following a known method, such as boiled water treatment, hot water treatment, vapor treatment, sodium silicate treatment, nitrite treatment, and ammonium acetate treatment. It is also possible to perform sealing treatment by using the apparatus and method as disclosed in JP 56-12518 B, JP 4-4194 A, JP 5-202496 A, or JP 5-179482 A for instance.

<Rinsing Treatment>

It is preferable to perform rinsing treatment with water after each step of any of the treatments as described above. The water to be used for rinsing may be pure water, well water, or tap water. In order to prevent the treatment liquid from being carried to the next step, a nip means may be employed. Rinsing treatment may be followed by the immersion in an acidic or alkaline solution for 1 to 60 seconds before another rinsing treatment.

<Protective Treatment>

The insulated light-reflective substrate of the present invention may be subjected to protective treatment so as to make it tolerant to a solvent used in a posttreatment for forming a metallic wiring layer for electric signal transmission to a LED, for patterning, for forming a metal layer on a LED mounting site, and so forth as described later.
Specifically, protective treatment allows an appropriate change of the anodized film surface in nature, from hydrophilic to hydrophobic (from lipophobic to lipophilic) or vice versa, as described in JP 2008-93652 A, JP 2009-68076 A, and so forth. A technique for imparting the resistance to acid/alkali may also be employed for the treatment as appropriate.

7. <Wiring Layer>

The wiring layer (metallic wiring layer) of the insulated light-reflective substrate of the present invention is described in detail.
The wiring layer is composed of a metal conductor, and provided on the anodized film as described before for use in the mounting of a light-emitting element.
The wiring layer may be provided on the anodized film on which a light-emitting element is to be mounted, or may be provided on the back side opposite with the side on which the anodized film is located, and electrically connected with the light-emitting element mounting face by way of through holes.
The material for the metallic wiring layer is not particularly limited as long as it is electrically conductive. Specific examples include gold (Au), silver (Ag), copper (Cu), aluminum (A1), magnesium (Mg), and nickel (Ni), which may each be used alone or in combination with one or more thereof.
Among the above, Cu is preferred because of its low electrical resistance. A Au layer or a Ni/Au layer may be provided on the surface of the wiring layer composed of Cu in order to facilitate wire bonding.
The thickness of the metallic wiring layer is preferably 0.5 to 1000 $\mu$m, more preferably 1 to 500 $\mu$m, and even more preferably 5 to 250 $\mu$m from the viewpoint of conduction reliability and package compactness.
Examples of the method of forming the metallic wiring layer include not only various plating treatments, such as electroplating, electroless plating and displacement plating, but sputtering, vapor deposition, vacuum adhesion of metal leaf, and adhesion by an adhesive layer.
Among others, formation of a layer composed solely of metal is preferred because such a layer has a high resistance to heat, and layer formation by plating treatment is particularly preferable in view of the fact that a thicker layer is formed uniformly, and a high adhesion is achieved.
During the plating treatment as above, it is preferable to initially provide a reduced metal layer called seed layer, then use the metal layer as provided to form a thicker metal layer because the plating treatment is to be performed on the anodized film.
The seed layer is preferably formed by electroless plating, whereupon the plating solution preferably comprises a principal component (e.g., a metal salt, a reductant) and an additional component (e.g., a pH adjusting agent, a buffer, a complexing agent, an accelerant, a stabilizer, a modifier). A commercially available plating solution, such as SE-650, -666 and -680, SEK-670 and -797, SFK-63 (each manufactured by Japan Kanigen Co., Ltd.), as well as MelPlate NI-4128, EnPlate NI-433, and EnPlate NI-411 (each manufactured by Meltex Inc.), may be employed as appropriate.
If copper is to be used as the material for the metallic wiring layer, a variety of electrolyte solutions containing sulfuric acid, copper sulfate, hydrochloric acid, polyethylene glycol and a surfactant as principal components and various additives as additional components are usable.
The metallic wiring layer thus formed is patterned by a known method in accordance with the LED packaging design. On the site on which a LED is actually to be mounted, another metal layer (including solder layer) may be provided as appropriate to an easy connection by thermocompression, flip-chip bonding, or wire bonding.
Suitable materials for the metal layer include solder as well as such metals as gold (Au), silver (Ag), copper (Cu), aluminum (Al), magnesium (Mg) and nickel (Ni), and it is preferable from the viewpoint of mounting a LED by heating to form a solder layer, or a Au or Ag layer along with an intervening layer of Ni, because a favorable connection reliability is achieved.
A patterned wiring layer can easily be formed on an irregular surface of the anodized film in need of less steps by using as a wiring-layer forming method the method in which metallic ink is used to make a pattern on the anodized film by the ink-jet printing or screen printing technique as described below. The wiring layer formed as above also has a good adhesion to the light-reflective layer owing to a significant anchoring effect of the micropores of the anodized film.

(Ink-jet Printing)

A wiring layer is formed on a desired part of the anodized film by an ink-jet printing technique using metallic ink containing a conductor metal. A wiring pattern is made with the metallic ink, then baked to attain wiring.

The metallic ink to be used is exemplified by that having fine particles of a conductor metal dispersed uniformly in a solvent containing a binder, a surfactant, and so forth. The solvent in such ink should possess both the affinity for the conductor metal and the volatility.

Examples of the conductor metal in a particulate form to be contained in the metallic ink include metals such as silver, copper, gold, platinum, nickel, aluminum, iron, palladium, chromium, molybdenum, and tungsten; metal oxides such as silver oxide, cobalt oxide, iron oxide, and ruthenium oxide; composite alloys such as Cr-Co-Mn-Fe, Cr-Cu, Cr-Cu-Mn, Mn-Fe-Cu, Cr-Co-Fe, Co-Mn-Fe, and Co-Ni-Cr-Fe; and plated composites such as silver-plated copper, which may each be used alone or in combination with one or more thereof.

Among the above, metals, especially silver, copper and gold, are preferable, whereupon silver is particularly preferred because it has so high a resistance to oxidation that the silver oxide which is strongly insulating is hard to produce, it is of low cost, and it brings about an improved conductivity of the wiring pattern after baked.

The conductor metal in a particulate form is not particularly limited in particle shape, that is to say, its fine particles may be of spherical shape, scaly shape, or other shape. A scaly shape is preferable from the viewpoint of increasing the contact area between fine particles so as to improve the conductivity.

The mean particle size of the conductor metal contained in the metallic ink is preferably 1 to 20 nm, more preferably 5 to 10 nm, taking into account that, with such a particle size, the filling rate of the conductor metal particles in the wiring pattern made with the metallic ink is increased to improvement in conductivity, and that the metallic ink containing the particles is brought onto the anodized film of the insulated substrate of the invention as described before.

(Screen Printing)

A wiring layer is formed on a desired part of the anodized film by a screen printing technique using metallic ink containing a conductor metal. A wiring pattern is made with the metallic ink, then baked to attain wiring.

In a screen printing technique, the metallic ink can be brought onto the anodized film by providing a screen with the passage portions following the wiring pattern that permit the metallic ink to pass through, and squeezing the ink to the anodized film through the passage portions.

The metallic ink containing a conductor metal to be used may be that usable in the ink-jet printing as described above.

8. <Application of Insulated Light-Reflective Substrate>

The insulated light-reflective substrate of the present invention is not particularly limited in type of the LED to be mounted thereon, in shape of a light-emitting element, or the like and, accordingly, finds wide application. In addition, the inventive substrate is usable as an insulated light-reflective substrate of a light-emitting device using a conventional LED.

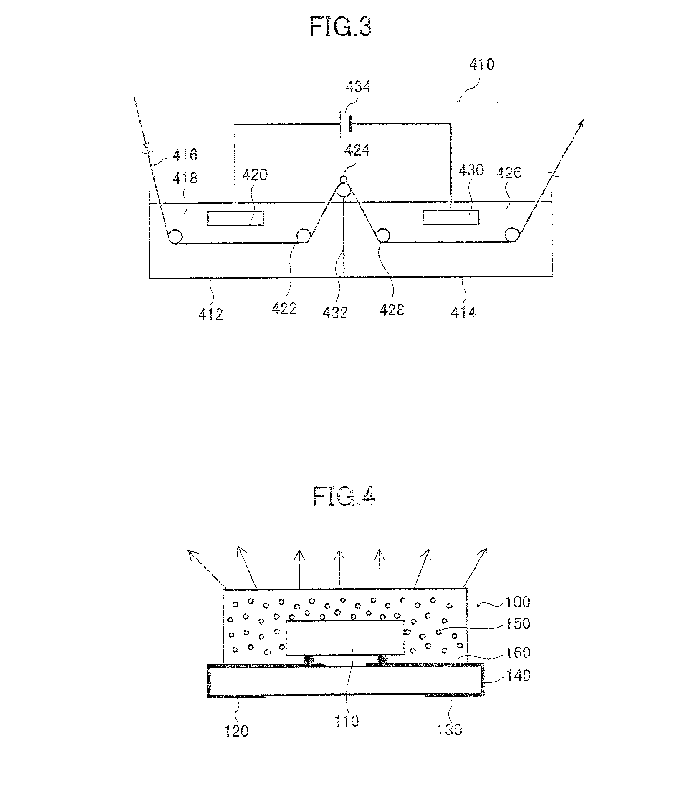

For instance, if the insulated light-reflective substrate 30 of the present invention is used instead of the substrate 140 as shown in Fig. 4, the luminance of a light-emitting device 100 is improved. The device 100 as shown in Fig. 4 is the white LED light-emitting device in which a light-emitting element 110 such as a blue LED is face-down bonded to the substrate 140 having electrodes 120 and 130 for external connection, and a transparent resin 160 having phosphor particles 150 of YAG type mixed therein is molded over the light-emitting element (blue LED) 110. The light from the phosphor particles 150 of YAG type excited and the afterglow of the light-emitting element (blue 1ED) 110 allow white light to be emitted from the light-emitting side of the white LED light-emitting device 100 in the directions of arrows.

The insulated light-reflective substrate of the present invention may also be used as a substrate of a fluorescence emitting device of such a structure that a blue LED is mounted on a substrate and sealed with a known resin, and a microstructured body (fluorescence emitting unit) as an anodized layer of a valve metal including a fluorescence emitter is provided on top of the sealed LED. Such a fluorescence emitting device is described in Japanese Patent Application No. 2009-134007 or 2009-139261.

Fig. 5A is a cross sectional view of the device 100 as the fluorescence emitting device in which the insulated light-reflective substrate 30 of the present invention has a metal plate 10 made of a SUS steel, for instance, as a core material, an aluminum alloy layer 1 on the surface of the plate 10, and an anodized film 2 at the surface of the layer 1.

On the insulated light-reflective substrate 30, the light-emitting element 110 is mounted and as such sealed with the transparent resin 160 including the phosphor particles 150. The metal plate 10, as being the core, is responsible for the mechanical strength and flexibility of the insulated light-reflective substrate of the present invention. The metal plate 10 may also serve as a heat sink to contribute to heat radiation. The light-emitting element 110 is bonded with a wire 9, and electrically connected with a required part of a wiring layer (not shown) formed on the anodized layer 2.

Fig. 5B is a cross sectional view of the device 100 as the fluorescence emitting device in which the insulated light-reflective substrate 30 of the present invention has an aluminum plate 11 and the anodized film 2 at the surface of the plate 11. On the insulated light-reflective substrate 30, the light-emitting element 110 is mounted and as such sealed with the transparent resin 160 including the phosphor particles 150.

The part of the aluminum plate 11 on which the light-emitting element 110 is to be mounted is recessed into the concaved portion 3, with its inner wall being inclined so that the portion 3 may open out toward the top. The light-emitting element 110 is mounted on the insulated light-reflective substrate 30 by die bonding or the like, and a heat sink 7 may be provided under the substrate 30. The light-emitting element 110 is bonded with a wire 9, and electrically connected with a required part of a wiring layer (not shown) formed on the anodized layer 2. The insulated light-reflective substrate of the present invention is of good insulation and high in total reflectance in the visible region, so that the light-emitting device 100 with the inventive substrate used as the substrate 30 has a high luminous efficacy.

The light-emitting element to be used has a layer of semiconductor, such as GaAlN, ZnS, ZnSe, SiC, GaP, GaAlAs, AlN, InN, AlInGaP, InGaN, GaN and AlInGaN, formed on a substrate as a light-emitting layer. The structure of the semiconductor may be a homo-, hetero- or double heterostructure with MIS, PIN or PN junction. The wavelength of the light to be emitted can be defined variously, from a UV wavelength to an IR wavelength, by selecting the material for the semiconductor layer or the mixed crystal ratio thereof as appropriate.

The transparent resin 160 is preferably a thermosetting resin. More preferably, the resin 160 is composed of at least one thermosetting resin selected from the group consisting of an epoxy resin, a modified epoxy resin, a silicone resin, a modified silicone resin, an acrylate resin, a urethane resin, and a polyimide resin, with an epoxy resin, a modified epoxy resin, a silicone resin and a modified silicone resin being particularly preferred. The transparent resin 160 is preferably hard in nature in terms of the protection of the light-emitting element 110. In addition, the resin to be used in the transparent resin 160 is preferably excellent in heat resistance, weatherability, and light resistance. The transparent resin 160 may have at least one selected from the group consisting of a filler, a diffusing agent, a pigment, a phosphor, a reflective substance, a UV absorber, and an antioxidant mixed therein in order to impart a specified function to the resin 160.

The phosphor particles 150 have only to be particles of the phosphor which absorbs the light from the light-emitting element 110 to convert it in wavelength. Preferably, the phosphor is at least one selected from among, for instance, nitride phosphors, oxynitride phosphors, sialon phosphors and β-sialon phosphors chiefly activated by a lanthanoid element such as Eu and Ce; alkaline earth halogen apatite phosphors, alkaline earth metal halogen borate phosphors, alkaline earth metal aluminate phosphors, alkaline earth silicate phosphors, alkaline earth sulfide phosphors, alkaline earth thiogallate phosphors, alkaline earth silicon nitride phosphors and germanate phosphors chiefly activated by a lanthanoid element such as Eu or a transition metal element such as Mn; or rare earth aluminate phosphors and rare earth silicate phosphors chiefly activated by a lanthanoid element such as Ce; or organic complexes chiefly activated by a lanthanoid element such as Eu.

As seen from the above, the insulated light-reflective substrate of the present invention may be used as a light-reflective substrate for the white LED light-emitting device in which an ultraviolet to blue LED, and a fluorescence emitter absorbing the light from the LED and emitting fluorescence in the visible region are used.

In such a light-emitting device, the fluorescence emitter absorbs blue light from the blue LED to emit fluorescence (yellow fluorescence), and this fluorescence and the afterglow of the blue LED allow white light to be emitted from the device.

The light-emitting system as above is of a so-called "pseudo white light-emitting type" combining one blue LED light source chip and one phosphor, namely, a yellow phosphor. The insulated light-reflective substrate of the present invention may also be used as a substrate for the light-emitting device in a light-emitting unit employing a conventional light-emitting system other than the above, such as the system of an "ultraviolet to near-ultraviolet light source type" combining one ultraviolet to near-ultraviolet LED light source chip and several phosphors, red, green and blue phosphors for instance, and the system of an "RGB source type" for emitting white light using three light sources emitting red, green and blue lights, respectively.

The method of mounting a light-emitting element on the wiring layer of the present invention involves heating. If a light-emitting element is to be mounted by thermocompression including solder reflowing or by flip-chip bonding, the ultimate temperature to be reached is preferably 220 to 350°C, more preferably 240 to 320°C, and even more preferably 260 to 300°C, and the period of time for which the ultimate temperature should be maintained is preferably 2 seconds to 10 minutes, more preferably 5 seconds to 5 minutes, and even more preferably 10 seconds to 3 minutes, in order to attain a uniform and secure mounting.

Heat treatment at some desired temperature may be performed for 5 seconds to 10 minutes, preferably 10 seconds to 5 minutes, and more preferably 20 seconds to 3 minutes before the ultimate temperature is reached for the purpose of suppressing generation of cracks in the anodized film due to the difference in coefficient of thermal expansion between the aluminum alloy layer and the anodized film of the insulated light-reflective substrate of the present invention. In that case, the desired temperature is preferably 80 to 200°C, more preferably 100 to 180°C, and even more preferably 120 to 160°C. With temperatures and periods of time under the above ranges, mounting of an element may be inadequate, while the substrate may be deteriorated with temperatures and periods of time over the above ranges.

The temperature during the mounting by wire bonding is preferably 80 to 300°C, more preferably 90 to 250°C, and even more preferably 100 to 200°C also in order to attain a secure mounting. The heating time is preferably 2 seconds to 10 minutes, more preferably 5 seconds to 5 minutes, and even more preferably 10 seconds to 3 minutes.

EXAMPLES

The present invention is illustrated by way of the following examples, to which the present invention is in no way limited.

(Examples 1 to 8 and Comparative Examples 1 to 3)

<Fabrication of Substrate>

Ingots of ultra pure aluminum (5N: 99.999 wt%; manufactured by Kyushu Mitsui Aluminium Co., Ltd.) were divided into 1 kg portions. Each portion was melted in a carbon crucible along with the relevant metal components, then cast into a carbon template (the interior capacity, 10 cm x 10 cm x 5 cm) and annealed to prepare an alloy ingot.

The ingot as prepared was milled for each face with a thickness of 1 cm so as to remove irregularities from the ingot surface. After the face milling, the ingot surface was washed with a solvent, and the ingot was subjected to a subsequent component analysis.

The component analysis of the alloy ingot was performed by using a glow discharge mass spectrometer (ELEMENT GD manufactured by Thermo Fisher Scientific K.K.) to quantify Al, Si, Fe, Ga and Zn and, at the same time, calculating the amount of inevitable impurities, namely, components other than Al, Si, Fe, Ga and Zn. The amount of inevitable impurities was defined as the total amount of copper, manganese, magnesium, chromium, bismuth, nickel and titanium.

After the component analysis, the alloy ingot was rolled on a cold rolling apparatus six times at a draft of 50%/pass, then subjected to the final rolling so that the plate thickness may eventually be 0.4 mm, so as to fabricate the substrate which was composed solely of an aluminum alloy layer having one of the compositions as set forth in Table 1 below.

From the rolled plate, a piece 10 cm wide and 15 cm long was obtained as a substrate (hereafter referred to as "aluminum alloy substrate"), and the graining treatment and anodizing treatment as described below were performed on the substrate.

<Graining Treatment (Formation of Asperities)>

Graining treatment was carried out by the following treatments (a) to (f). At the end of each treatment and rinsing, liquid was removed with nip rollers.

(a) Degreasing Treatment

The surface of the aluminum alloy substrate was brought into contact with a solution containing a surfactant and rinsed with water, then brought into contact with a 15 g/L aqueous sulfuric acid solution to dissolve the surface. Subsequently, the surface of the aluminum alloy substrate was rinsed with water.

(b) Alkali Etching Treatment

The aluminum alloy substrate was subjected to etching treatment with a spray of an aqueous solution at a temperature of 70°C having a sodium hydroxide concentration of 2.6% by weight and an aluminum ion concentration of 6.5% by weight so as to dissolve the substrate at a rate of 1 g/m$^2$. Subsequently, the aluminum alloy substrate was rinsed with a spray of water.

(c) Desmutting Treatment

The aluminum alloy substrate was subjected to desmutting treatment with a spray of a 1 wt% aqueous nitric acid solution (containing 0.5% by weight aluminum ions) at a temperature of 30°C, then rinsed with a spray of water. The aqueous nitric acid solution as used for the desmutting treatment was a waste liquid derived from the electrochemical graining treatment which was performed in an aqueous nitric acid solution using alternating current.

(d) Electrochemical Graining Treatment

Electrochemical graining treatment was continuously performed using AC voltage at 60 Hz. The electrolyte solution was a 9.0 g/L aqueous nitric acid solution (containing 5 g/L aluminum ions and 0.007% by weight ammonium ions) at a temperature of 50°C. The AC power supply waveform was as shown in Fig. 1, and electrochemical graining treatment was carried out using the alternating current having a trapezoidal waveform, with the time TP in which the current value changes from zero to a peak being 0.8 msec and the duty ratio 1:1, and a carbon electrode as a counter electrode. Ferrite was used for an auxiliary anode. The electrolytic cell as shown in Fig. 2 was used as the one for this treatment. The current density was 30 A/dm$^2$ at current peaks, and the total amount of electricity when the aluminum alloy substrate serves as an anode was 220 C/dm$^2$. The current from the power supply was shunted to the auxiliary anode at a ratio of 5%. After the treatment, the aluminum alloy substrate was rinsed with a spray of water.

(e) Alkali Etching Treatment

The aluminum alloy substrate was subjected to etching treatment at a temperature of 32°C, with the treatment being performed with a spray of an aqueous solution having a sodium hydroxide concentration of 26% by weight and an aluminum ion concentration of 6.5% by weight, so as to dissolve the substrate at a rate of 10 g/m$^2$, remove aluminum hydroxide-based smuts generated during the previous electrochemical graining treatment using alternating current, and dissolve the edges of the asperities as formed by the electrochemical graining treatment to make the edges smooth. Subsequently, the aluminum alloy substrate was rinsed with a spray of water.

(f) Desmutting Treatment

The aluminum alloy substrate was subjected to desmutting treatment with a spray of a 15 wt% aqueous nitric acid solution (containing 4.5% by weight aluminum ions) at a temperature of 30°C, then rinsed with a spray of water. The aqueous nitric acid solution as used for the desmutting treatment was a waste liquid derived from the electrochemical graining treatment which was performed in an aqueous nitric acid solution using alternating current.

<Anodizing Treatment (Formation of Anodized Film)>

Anodizing treatment was performed using an anodization apparatus of the structure as shown in Fig. 3 to obtain an insulated light-reflective substrate having an anodized film on the surface of the aluminum alloy substrate.

Using sulfuric acid as an electrolyte solution, anodization was conducted for eight hours under such conditions that the sulfuric acid concentration was 0.3 M, the temperature was 17°C, and the voltage was 25 V. Subsequently, the aluminum alloy substrate was rinsed with a spray of water. The thickness of the anodized film as finally obtained was 45 μm.

(Comparative Examples 4 and 5)

The alloy ingots of Example 4 and Comparative Example 2 were used for Comparative Examples 4 and 5, respectively. Graining treatment was carried out by the above treatments (a) to (f), then anodizing treatment was performed under the conditions as below to obtain insulated light-reflective substrates.

<Anodizing Treatment>

Anodizing treatment was performed using an anodizaion apparatus of the structure as shown in Fig. 3. Sulfuric acid was used as an electrolyte solution to conduct anodization for 40 minutes under such conditions that the sulfuric acid concentration was 1.8 M, the temperature was 45°C, and the current density was 20 A/dm$^2$. Subsequently, the aluminum alloy substrate was rinsed with a spray of water. The thickness of the anodized film as finally obtained was 45 μm.

(Examples 9 to 11)

An aluminum alloy substrate fabricated in accordance with Example 4 was rolled to a thickness of 0.8 mm to use the resultant plate as a clad material, and ingots of the alloys A to C as set forth in Table 2 below were used as core materials. The clad material and each core material were stacked together, with a brazing material being sandwiched between them, and subjected as such to heat treatment in a furnace at 500°C for three hours. The stacks were each hot rolled to bond the materials together by compression so as to fabricate the substrates of Examples 9 to 11.

The substrates thus fabricated were subjected to the same graining treatment and anodizing treatment as Example 1 to obtain insulated light-reflective substrates each having an anodized film (45 $\mu$m thick) on the surface of the substrate.

(Examples 12 to 14 and Comparative Example 6)

The aluminum alloy substrate fabricated in Example 4 was melted in a furnace, and a stainless steel plate (SUS 403, No. 2B material; the thickness, 0.3 mm) was immersed in the melt to fabricate the substrate which includes the stainless steel plate (core) provided on its surface with an aluminum alloy layer about 100 $\mu$m thick. The substrate was defined as the substrate of Example 12.

Similarly, a stainless steel plate (SUS 403) with a zinc plating layer (about 10 $\mu$m thick) provided thereon in advance by immersing the plate in an aluminum-containing zinc hot-dipping bath was immersed in a hot-dipping bath prepared by melting the aluminum alloy substrate fabricated in Example 4, so as to fabricate the substrate which includes the stainless steel plate provided on its zinc plating layer with an aluminum alloy layer about 100 $\mu$m thick. The substrate was defined as the substrate of Example 13.

Similarly, a stainless steel plate (SUS 304) was immersed in the aluminum alloy of Example 4 as melted in a furnace to fabricate the substrate which includes the stainless steel plate (core) provided on its surface with an aluminum alloy layer about 100 $\mu$m thick. The substrate was defined as the substrate of Example 14.

Similarly, a stainless steel plate (SUS 304) was immersed in the aluminum alloy of Comparative Example 5 as melted in a furnace to fabricate the substrate which includes the stainless steel plate (core) provided on its surface with an aluminum alloy layer about 100 $\mu$m thick. The substrate was defined as the substrate of Comparative Example 6.

The stainless steel plates as used for the fabrication of the above substrates were previously treated with a 10% aqueous iron (III) chloride solution (40°C) for three minutes to grain their surfaces.

When the substrates thus fabricated were analyzed in composition, it was found that the thickness of the transition region between the aluminum alloy layer and the stainless steel plate (namely the layer in which Fe as a major component of stainless steel was diffused) was about 50 $\mu$m in any of the substrates and, accordingly, it could be considered that the aluminum alloy layer as a clad was kept intact in component from the layer surface up to a depth of not more than 50 $\mu$m.

The substrates were subjected to the same degreasing treatment (a) and anodizing treatment as Example 1 to obtain insulated light-reflective substrates each having an anodized film (45 $\mu$m thick) on the surface of the substrate.

(Examples 15 to 17)

In each of Examples 15 to 17, the alloy ingot of Example 4 was used to fabricate a substrate, and the substrate was subjected to the same graining treatment as that carried out by the above treatments (a) to (f). In addition, each substrate was successively subjected to anodizing treatment with sulfuric acid and anodizing treatment with boric acid in this order under the conditions as described below to obtain an insulated light-reflective substrate.

<Anodizing Treatment with Sulfuric Acid>

Using sulfuric acid as an electrolyte solution, anodization was conducted for eight hours for Example 15, and for five hours for Examples 16 and 17 under such conditions that the sulfuric acid concentration was 30 g/L, the temperature was 17°C, and the voltage was 25 V. Subsequently, each substrate was rinsed with a spray of water.

The thickness of the anodized film as formed by the anodizing treatment with sulfuric acid was 45 $\mu$m in Example 15, and 25 $\mu$m in each of Examples 16 and 17.

<Anodizing Treatment with Boric Acid>

In an aqueous solution at a temperature of 20°C having a boric acid concentration of 30 g/L and a sodium borate concentration of 20 g/L, DC electrolysis was conducted for 60 minutes at a voltage of 600 V for Examples 15 and 16, and at a voltage of 300 V for Example 17, so as to perform anodizing treatment on the inside of micropores generated during the anodizing treatment with sulfuric acid.

The thickness of the anodized film formed by the anodizing treatment with boric acid was 0.4 $\mu$m (400 nm) in each of Examples 15 and 16, and 0.2 $\mu$m (200 nm) in Example 17, both values having met the perpendicular depth L as defined by the above Equation (a).

It should be noted that, in the case of Examples 15 and 16, the calculated value of the depth L is 197 nm if m is 1, and 394 nm if m is 2 assuming that the target wavelength is 450 nm. In the case of Example 17, the calculated value of the depth L is 202 nm if m is 2, and 303 nm if m is 3 assuming that the target wavelength is 330 nm.

(Example 18)

In Example 18, the alloy ingot of Example 4 was used to fabricate a substrate, and the substrate was subjected to the same graining treatment as that carried out by the above treatments (a) to (f). The substrate was further subjected to anodizing treatment with sulfuric acid under the conditions as described below to obtain an insulated light-reflective substrate.

<Anodizing Treatment with Sulfuric Acid>

The substrate was subjected to DC electrolysis at a voltage of 16 V for three hours in an aqueous solution at a temperature of 20°C having a sulfuric acid concentration of 70 g/L, then rinsed with a spray of water. The thickness of the anodized film formed by the anodization with sulfuric acid was 25 $\mu$m.

(Comparative Example 7)

In Comparative Example 7, the alloy ingot of Example 4 was used to fabricate a substrate, and the substrate was subjected to the same graining treatment as that carried out by the above treatments (a) to (f). The substrate was further subjected to anodizing treatment with boric acid under the conditions as described below to obtain an insulated light-reflective substrate.

<Anodizing Treatment with Boric Acid>

The substrate was subjected to DC electrolysis at a voltage of 300 V for 60 minutes in an aqueous solution at a temperature of 20°C having a boric acid concentration of 30 g/L and a sodium borate concentration of 20 g/L, then rinsed with a spray of water. The thickness of the anodized film formed by the anodizing treatment with boric acid was 0.4 $\mu$m.

(Example 19)

In Example 19, the alloy ingot of Example 4 was used to fabricate a substrate, and the substrate was subjected to the same graining treatment and anodizing treatment as Example 4 except that the mechanical graining treatment (g) as described below was performed after the above treatment (a), and the above treatment (f) was omitted, so as to obtain an insulated light-reflective substrate having an anodized film (45 $\mu$m thick) on the surface of the substrate.

(g) Mechanical Graining Treatment

On the apparatus as shown in Fig. 7, mechanical graining treatment was performed by applying nylon brushes in the form of rotating rollers onto the surface of the aluminum alloy substrate while feeding the surface with a suspension of an abrasive (pumice) in water (the specific gravity, 1.12) as an abrasive slurry.

Fig. 7 shows an aluminum alloy substrate 21, roller brushes 22 and 24, an abrasive slurry 23, and support rollers 25, 26, 27 and 28. The abrasive used had a mean particle size of 40 $\mu$m and a maximum particle size of 100 $\mu$m. The bristles of the nylon brushes were made of nylon 6.10, and had a length of 50 mm and a diameter of 0.3 mm. The nylon brushes were fabricated by inserting the bristles tightly in holes provided in stainless steel cylinders with a diameter of 300 mm. The rotating brushes used were three in number. Two support rollers (with a diameter of 200 mm) under each brush were 300 mm distant from each other. Each roller brush was pressed onto the aluminum alloy substrate to such an extent that the load on the motor for rotatively driving the relevant brush was increased by 7 kW with respect to that before the pressing of the brush. The rotational direction of the brushes was the same as the direction in which the aluminum alloy substrate was moved. The number of revolutions of the brushes was 200 rpm.

(Example 20)

In Example 20, the alloy ingot of Example 4 was used to fabricate a substrate, and the substrate was subjected to the above treatments (a), (g), (b) and (c) in this order, then to the same anodizing treatment with sulfuric acid as Example 18 to obtain an insulated light-reflective substrate having an anodized film (25 $\mu$m thick) on the surface of the substrate.

(Example 21)

In Example 21, the alloy ingot of Example 4 was used to fabricate a substrate, and the substrate was subjected to the above treatments (a), (g), (b) to (e), as well as the electrochemical graining treatment (h) and alkali etching treatment (i) as described below in this order, then to the same anodizing treatment with sulfuric acid as Example 18 to obtain an insulated light-reflective substrate having an anodized film (25 $\mu$m thick) on the surface of the substrate.

(h) Electrochemical Graining Treatment

Electrochemical graining treatment was continuously performed using AC voltage at 60 Hz to form a large undulation. The electrolyte solution was a 15.0 g/L aqueous hydrochloric acid solution (containing 10 g/L aluminum ions) at a temperature of 50°C. The sinusoidal waveform as shown in Fig. 1 was used as an AC power supply waveform, and a carbon electrode was employed as a counter electrode. The electrolytic cell as shown in Fig. 2 was used as the one for this treatment. The current density was 22 A/dm$^2$ at current peaks, and the total amount of electricity when the aluminum alloy substrate serves as an anode was 50 C/dm$^2$. After the treatment, the aluminum alloy substrate was rinsed with a spray of water.

(i) Alkali Etching Treatment

The aluminum alloy substrate was subjected to etching treatment at a temperature of 32°C, with the treatment being performed with a spray of an aqueous solution having a sodium hydroxide concentration of 5% by weight and an aluminum ion concentration of 0.5% by weight. The aluminum alloy substrate was dissolved at a rate of 5 g/m$^2$ under standardized conditions so as to remove aluminum hydroxide-based smuts generated during the previous electrochemical graining treatment using alternating current, and dissolve the edges of the asperities as formed by the electrochemical graining treatment to make the edges smooth. After the treatment, the aluminum alloy substrate was rinsed with a spray of water. Subsequently, desmutting treatment was performed by spraying the substrate surface with a 15 wt% aqueous sulfuric acid solution (containing 4.5% by weight aluminum ions) at a temperature of 30°C before the substrate was rinsed with a spray of water.

(Example 22)

In Example 22, the alloy ingot of Example 4 was used to fabricate a substrate, and the substrate was subjected to the above treatments (a) to (e), (h) and (i) in this order, then to the same anodizing treatment with sulfuric acid as Example 18 to obtain an insulated light-reflective substrate having an anodized film (25 $\mu$m thick) on the surface of the substrate.

(Example 23)

Following the procedure of Example 22 except that the alkali dissolution rate in the above treatment (i) was 2 g/m$^2$, an insulated light-reflective substrate was obtained.

(Example 24)

A stable Au ink dispersion was prepared by adding 50 g of Au nanoparticles (NanoTek manufactured by C. I. Kasei Co., Ltd.) to 50 g of xylene, and agitating the mixture at room temperature for eight hours. According to the solid powder analysis of the ink dispersion, the gold content was 26.8% by weight.

Into the ink dispersion, a silane coupling agent (KBM 603 manufactured by Shin-Etsu Polymer Co., Ltd.) was mixed in an amount of 2% by weight on the amount of the ink dispersion to prepare metal ink. The resultant metal ink had a viscosity of 10 cps.

By an ink-jet printing technique using a Dimatix materials printer (DMP-2831 manufactured by FUJIFILM Dimatix, Inc.), the metal ink was brought onto the anodized film of the insulated light-reflective substrate as obtained in Example 2, and dried for about five minutes by a hot air dryer set at 160°C so as to achieve Au metal wiring.

<Determination of Ratio of Micropore Center Line Length to Micropore Depth (Length/Depth Ratio)>

The anodized film of each of the insulated light-reflective substrates as obtained was observed in cross section with an FE-SEM (S-4000 manufactured by Hitachi, Ltd.), and micropores in the film were measured in depth and center line length to determine the mean ratio of the center line length to the depth (length/depth ratio) of the micropores. The results are set forth in Table 1 below.

<Measurement of Surface Profile>

With respect to the surface asperities of each of the insulated light-reflective substrates as obtained, the measurements (1) to (3) as described below were conducted to calculate the mean wavelengths of structures with large undulation, medium undulation and small undulation, respectively.
The results are set forth in Table 1 below. In the table, the symbol "-" indicates that asperities at the relevant mean wavelength were absent.

(1) Mean Wavelength of Structure with Large Undulation

Two-dimensional surface roughness measurement was conducted with a stylus-type surface roughness tester (SURFCOM 575 manufactured by TOKYO SEIMITSU CO., LTD.), and the mean spacing of profile irregularities $S_m$ as defined in ISO 4287 was measured five times to find the mean of measured values as the mean wavelength. The conditions for two-dimensional surface roughness measurement were as follows.
Measurement Conditions:

cutoff value, 0.8 mm; tilt correction, FLAT-ML; measurement length, 3 mm; vertical magnification, 10,000x; scan rate, 0.3 mm/sec; stylus tip diameter, 2 $\mu$m.

(2) Mean Wavelength of Structure with Medium Undulation

A scanning electron microscope (SEM) was used to photograph the surface of each insulated light-reflective substrate at 2,000$\times$ magnification from right above. In the SEM photograph obtained, recesses and protrusions with continuous annular edges of a structure with medium undulation were extracted, with their number being 50 in total, to read their diameters as wavelengths, and the mean wavelength was calculated.

(3) Mean Wavelength of Structure with Small Undulation

A scanning electron microscope (SEM) of high resolution was used to photograph the surface of each insulated light-reflective substrate at 50,000$\times$ magnification from right above. In the SEM photograph obtained, recesses and protrusions of a structure with small undulation were extracted, with their number being 50 in total, to read their diameters as wavelengths, and the mean wavelength was calculated.
In order to find the surface area difference $\Delta S$ of the surface of each insulated light-reflective substrate as obtained, the relevant substrate was measured in surface profile with an atomic force microscope (SPI3700 manufactured by Seiko Instruments Inc.) to obtain three-dimensional data. Specific procedure is described below.
A 1 cm square sample was cut out from the insulated light-reflective substrate and set on a horizontal sample holder mounted on a piezoelectric scanner. A cantilever was caused to approach the surface of the sample until atomic forces were appreciable and then the surface was scanned in the X and Y directions to acquire the surface asperities of the sample based on the piezoelectric displacement in the Z direction. The piezoelectric scanner as used is capable of scanning 150 $\mu$m in the X and Y directions and 10 $\mu$m in the Z direction, and the cantilever (SI-DF20 manufactured by NANOPROBE Corporation) has a resonance frequency of 120 to 150 kHz and a spring constant of 12 to 20 N/m. Measurement was carried out in the dynamic force mode (DFM). The three-dimensional data as obtained was approximated by the least-squares method to compensate for slight tilting of the sample and determine a reference plane.
Measurement was performed at 512 $\times$ 512 points in a 50 $\mu$m square region of the sample surface. The resolution was 1.9 $\mu$m in the X and Y directions and 1 nm in the Z direction, and the scan rate was 60 $\mu$m/sec.
Using the three-dimensional data (f(x, y)) thus obtained, sets of adjacent three points were extracted, and the areas of minimal triangles defined by the individual sets of three points were summated, with the summation being assumed as the actual area $S_x$. The surface area difference $\Delta S$ was calculated from the resulting actual area $S_X$ and the geometrically measured area $S_0$ (50 $\mu$m $\times$ 50 $\mu$m) using Equation (I) as described before.

The results are set forth in Table 1 below.

<Measurement of Optical Reflectance>

With respect to each insulated light-reflective substrate as obtained, a spectral reflectance measuring instrument (SP64 manufactured by X-Rite Corporation) was used to measure the mean total reflectance in the visible region (400 to 800 nm) and a UV region (300 to 320 nm). The results are set forth in Table 1.

<Measurement of Dielectric Strength>

With respect to each insulated light-reflective substrate as obtained, the breakdown voltage (dielectric strength) in oil was measured with a 10 kV dielectric breakdown testing instrument (manufactured by Yamayo Shikenki Limited) following the method as defined in JIS C2110. Measurement was made at three points to find the mean of measured values as the dielectric strength. The results are set forth in Table 1.

<Recognition of Light Emitted>

The aluminum alloy substrate fabricated in Example 4 and the cladded substrate fabricated in Example 13 were subjected to stamping to form thereon concaved portions, 5 mm square in contour and 0.2 mm deep each, with 40 mm pitches.
Subsequent to the stamping, the substrate of Example 4 was subjected to the surface treatments of Examples 1, 15 and 18 to obtain three insulated light-reflective substrates, respectively.
On the other hand, the substrate of Example 13 was subsequently subjected to the surface treatment of Example 1 to obtain one insulated light-reflective substrate.
The insulated light-reflective substrates thus obtained and the non-stamped substrates (insulated light-reflective substrates as obtained in Examples 4 and 13) were each singulated by dicing into 40 mm square pieces, whereupon the pieces of the stamped substrates were each made to have the 5 mm square concaved portion in the center.
To each substrate piece, the copper wiring pattern accompanied by an adhesive layer that had previously been prepared was bonded by thermocompression so as to provide wiring on the relevant substrate piece.
Then, copper wires were arranged so that wire tips opposite to each other might be located with a distance of 3 mm therebetween. In consequence, the copper wires were allowed to lie at their tips inside the concaved portion if the portion was present.
In the case of the non-stamped substrates, a 5 mm square resist with a height of 120 $\mu$m was printed on each substrate piece by a screen printing technique so that the resist, as being aligned, might include copper wires therein, and banks of a sealant were formed.
A LED chip was die bonded to the center of the concaved portion or embanked portion of each substrate piece, and connected with the copper wiring by wire bonding. A silicone sealant was caused to drop down so as to seal the LED chip and wire bonded parts to complete a LED package.
It was confirmed that light was emitted from both types of LED packages, that is to say, from both the packages with stamped substrates and the packages with non-stamped substrates. The LED packages with stamped substrates emitted light in a larger amount because the stamped substrates served as a reflector also in the parts corresponding to those of the non-stamped substrates where sealant banks were formed.

Table 1(1/3)

| | Substrate | | | | | | | | | | Core |
|---|---|---|---|---|---|---|---|---|---|---|---|
| | Aluminium alloy layer | | | | | | | | | | |
| | Al (wt%) | Si (wt%) | Fe (wt%) | Si+Fe (wt%) | Ti (wt%) | Ga (ppm) | Zn (ppm) | Inevit. impurities (wt%) | Thickness (μm) | | |
| Ex. 1 | 99.998 | 0.00014 | 0.00010 | 0.00024 | 0.0003 | 2 | 4 | 0.0010 | 400 | | None (aluminum alloy layer only) |
| Ex. 2 | 99.996 | 0.00013 | 0.00012 | 0.00025 | 0.0003 | 16 | 3 | 0.0013 | 400 | | |
| Ex. 3 | 99.993 | 0.00014 | 0.00010 | 0.00024 | 0.0003 | 2 | 10.8 | 0.0048 | 400 | | |
| Ex.4 | 99.990 | 0.00014 | 0.00010 | 0.00024 | 0.0005 | 12 | 7.3 | 0.0072 | 400 | | |
| Ex. 5 | 99.990 | 0.00130 | 0.00210 | 0.00340 | 0.0002 | 3 | 3 | 0.0020 | 400 | | |
| Ex. 6 | 99.989 | 0.00130 | 0.00210 | 0.00340 | 0.0002 | 16 | 15 | 0.0012 | 400 | | |
| Ex. 7 | 99.994 | 0.00014 | 0.00010 | 0.00024 | 0.0003 | 34 | 3 | 0.0016 | 400 | | |
| Ex. 8 | 99.993 | 0.00014 | 0.00010 | 0.00024 | 0.0007 | 4 | 23 | 0.0032 | 400 | | |
| Comp. Ex. 1 | 99.985 | 0.00230 | 0.00300 | 0.00530 | 0.0004 | 7 | 10.2 | 0.0024 | 400 | | |
| Comp. Ex. 2 | 99.965 | 0.00400 | 0.01000 | 0.01400 | 0.0006 | 18 | 19 | 0.0027 | 400 | | |
| Comp. Ex. 3 | 99.979 | 0.00014 | 0.00010 | 0.00024 | 0.0070 | 2 | 4 | 0.0130 | 400 | | |
| Comp. vEx. 4 | 99.990 | 0.00014 | 0.00010 | 0.00024 | 0.0005 | 12 | 7.3 | 0.0072 | 400 | | |
| Comp. Ex. 5 | 99.965 | 0.00400 | 0.01000 | 0.01400 | 0.0006 | 18 | 19 | 0.0027 | 400 | | |
| Ex. 9 | 99.990 | 0.00014 | i 0.00010 | 0.00024 | 0.0005 | 12 | 7.3 | 0.0072 | 80 | | Alloy A (Table 2) |
| Ex. 10 | 99.990 | 0.00014 | 0.00010 | 0.00024 | 0.0005 | 12 | 7.3 | 0.0072 | 80 | | Alloy B (Table 2) |
| Ex. 11 | 99.990 | 0.00014 | 0.00010 | 0.00024 | 0.0005 | 12 | 7.3 | 0.0072 | 80 | | Alloy C (Table 2) |
| Ex. 12 | 99.990 | 0.00014 | 0.00010 | 0.00024 | 0.0005 | 12 | 7.3 | 0.0072 | 50 | | SUS 403 |

(continued)

| | Substrate | | | | | | | | | Core |
|---|---|---|---|---|---|---|---|---|---|---|
| | Aluminium alloy layer | | | | | | | | | |
| | Al (wt%) | Si (wt%) | Fe (wt%) | Si+Fe (wt%) | Ti (wt%) | Ga (ppm) | Zn (ppm) | Inevit. impurities (wt%) | Thickness (μm) | |
| Ex. 13 | 99.990 | 0.00014 | 0.00010 | 0.00024 | 0.0005 | 12 | 7.3 | 0.0072 | 50 | Zinc-plated SUS 403 |
| Ex. 14 | 99.990 | 0.00014 | 0.00010 | 0.00024 | 0.0005 | 12 | 7.3 | 0.0072 | 50 | SUS 304 |
| Comp. Ex. 6 | 99.965 | 0.00400 | 0.01000 | 0.01400 | 0.0006 | 18 | 19 | 0.0027 | 50 | SUS 304 |
| Ex. 15 | 99.990 | 0.00014 | 0.00010 | 0.00024 | 0.0005 | 12 | 7.3 | 0.0072 | 400 | None (aluminum alloy layer only) |
| Ex. 16 | 99.990 | 0.00014 | 0.00010 | 0.00024 | 0.0005 | 12 | 7.3 | 0.0072 | 400 | |
| Ex. 17 | 99.990 | 0.00014 | 0.00010 | 0.00024 | 0.0005 | 12 | 7.3 | 0.0072 | 400 | |
| Ex. 18 | 99.990 | 0.00014 | 0.00010 | 0.00024 | 0.0005 | 12 | 7.3 | 0.0072 | 400 | |
| Comp. Ex. 7 | 99.990 | 0.00014 | 0.00010 | 0.00024 | 0.0005 | 12 | 7.3 | 0.0072 | 400 | |
| Ex.19 | 99.990 | 0.00014 | 0.00010 | 0.00024 | 0.0005 | 12 | 7.3 | 0.0072 | 400 | |
| Ex. 20 | 99.990 | 0.00014 | 0.00010 | 0.00024 | 0.0005 | 12 | 7.3 | 0.0072 | 400 | |
| Ex. 21 | 99.990 | 0.00014 | 0.00010 | 0.00024 | 0.0005 | 12 | 7.3 | 0.0072 | 400 | |
| Ex. 22 | 99.990 | 0.00014 | 0.00010 | 0.00024 | 0.0005 | 12 | 7.3 | 0.0072 | 400 | |
| Ex. 23 | 99.990 | 0.00014 | 0.00010 | 0.00024 | 0.0005 | 12 | 7.3 | 0.0072 | 400 | |

Table 1 (2/3)

| | Anodized layer | |
| --- | --- | --- |
| | Thickness (μm) | Length/depth ratio of micropores |
| Ex. 1 | 45 | 1.20 |
| Ex. 2 | 45 | 1.04 |
| Ex. 3 | 45 | 1.12 |
| Ex. 4 | 45 | 1.01 |
| Ex. 5 | 45 | 1.18 |
| Ex. 6 | 45 | 1.19 |
| Ex. 7 | 45 | 1.10 |
| Ex. 8 | 45 | 1.15 |
| Comp. Ex. 1 | 45 | 1.23 |
| Comp. Ex. 2 | 45 | 1.28 |
| Comp. Ex.3 | 45 | 1.25 |
| Comp. Ex. 4 | 45 | 1.34 |
| Comp. Ex. 5 | 45 | 1.86 |
| Ex. 9 | 45 | 1.01 |
| Ex. 10 | 45 | 1.01 |
| Ex.11 | 45 | 1.02 |
| Ex. 12 | 45 | 1.01 |
| Ex. 13 | 45 | 1.04 |
| Ex. 14 | 45 | 1.01 |
| Comp. Ex. 6 | 45 | 1.31 |
| Ex.15 | 45 | 1.11 |
| Ex. 16 | 25 | 1.05 |
| Ex.17 | 25 | 1.19 |
| Ex. 18 | 25 | 1.14 |
| Comp. Ex. 7 | 0.4 | no pores |
| Ex. 19 | 45 | 1.11 |
| Ex. 20 | 25 | 1.05 |
| Ex. 21 | 25 | 1.19 |
| Ex. 22 | 25 | 1.14 |
| Ex. 23 | 25 | 1.14 |

Table 1 (3/3)

| | Insulated light-reflective substrate | | | | | | |
|---|---|---|---|---|---|---|---|
| | Mean wavelength (μm) | | | ΔS (%) | Total reflectance | | Dielectric strength (V) |
| | Structure with large undulation | Structure with medium undulation | Structure with small undulation | | Visible region | 300-320 nm | |
| Ex.1 | - | 2.0 | - | 4 | 80% | 76% | 1320 |
| Ex. 2 | - | 2.0 | - | 4 | 92% | 87% | 1200 |
| Ex. 3 | - | 2.0 | - | 4 | 85% | 83% | 1300 |
| Ex. 4 | - | 2.0 | - | 4 | 96% | 94% | 1250 |
| Ex. 5 | - | 2.0 | - | 4 | 73% | 70% | 1010 |
| Ex. 6 | - | 2.0 | - | 4 | 78% | 72% | 1000 |
| Ex. 7 | - | 2.0 | - | 4 | 92% | 90% | 980 |
| Ex. 8 | - | 2.0 | - | 4 | 84% | 75% | 950 |
| Comp. Ex. 1 | - | 2.0 | - | 4 | 65% | 58% | 950 |
| Comp. Ex. 2 | - | 2.0 | - | 4 | 51% | 48% | 760 |
| Comp. Ex. 3 | - | 2.0 | - | 4 | 63% | 59% | 800 |
| Comp. Ex. 4 | - | 2.0 | - | 4 | 64% | 57% | 1300 |
| Comp. Ex. 5 | - | 2.0 | - | 4 | 32% | 31% | 740 |
| Ex.9 | - | 2.0 | - | 4 | 90% | 84% | 1220 |
| Ex. 10 | - | 2.0 | - | 4 | 88% | 86% | 1150 |
| Ex. 11 | - | 2.0 | - | 4 | 93% | 91% | 1200 |
| Ex. 12 | - | 2.0 | - | 4 | 96% | 91% | 1250 |
| Ex.13 | - | 2.0 | - | 4 | 95% | 86% | 1240 |
| Ex. 14 | - | 2.0 | - | 4 | 96% | 93% | 1250 |
| Comp. Ex. 6 | - | 2.0 | - | 4 | 30% | 21% | 780 |
| Ex. 15 | - | 2.0 | - | 4 | 96% | 95% | 1450 |
| Ex. 16 | - | 2.0 | - | 4 | 95% | 96% | 1180 |
| Ex. 17 | - | 2.0 | - | 4 | 90% | 92% | 1340 |
| Ex. 18 | - | 2.0 | - | 4 | 97% | 95% | 1190 |
| Comp. Ex. 7 | - | 2.0 | - | 4 | 90% | 94% | 280 |
| Ex.19 | 40.0 | 2.0 | - | 8 | 72% | 70% | 1120 |
| Ex. 20 | 40.0 | - | - | 2 | 80% | 78% | 1180 |
| Ex. 21 | 40.0 | 2.0 | 0.2 | 28 | 70% | 60% | 1060 |
| Ex. 22 | - | 2.0 | 0.2 | 6 | 82% | 80% | 1290 |

(continued)

| | Insulated light-reflective substrate | | | | | | |
| --- | --- | --- | --- | --- | --- | --- | --- |
| | Mean wavelength ($\mu$m) | | | ΔS (%) | Total reflectance | | Dielectric strength (V) |
| | Structure with large undulation | Structure with medium undulation | Structure with small undulation | | Visible region | 300-320 nm | |
| Ex. 23 | - | 2.0 | 0.2 | 15 | 70% | 68% | 1170 |

Table 2

| | Component contained | | | | | | | |
| --- | --- | --- | --- | --- | --- | --- | --- | --- |
| | Si (wt%) | Fe (wt%) | Cu (wt%) | Mg (wt%) | Ga (ppm) | Zn (ppm) | Ti (wt%) | Others |
| Alloy A | 12 | 0.30 | 0.8 | 0.9 | 10 | 80 | 0.010 | Al as the balance |
| Alloy B | 0.23 | 0.9 | 2.1 | 1.4 | 14 | 12.4 | 0.040 | Al as the balance |
| Alloy C | 0.18 | 0.30 | 0.001 | 4.4 | 20 | 40 | 0.010 | Al as the balance |

As seen from Examples, the relationship of the amounts of aluminum alloy components with the optical reflectance and the dielectric strength is characterized by the following.

1) Both the dielectric strength and the optical reflectance are high if the Si + Fe content is not more than 0.005% by weight, and inevitable impurities as components other than Al, Si, Fe, Ga and Zn are contained in an amount of not more than 0.01% by weight.
2) Both the dielectric strength and the optical reflectance are also high if the ratio of the center line length to the depth (length/depth ratio) of the micropores in the anodized film is 1.0 to 1.2.
3) The optical reflectance is improved by the addition of a specified amount of Ga or Zn if the Si + Fe content is not more than 0.005% by weight.
4) The optical reflectance is further improved by the combined application of Ga and Zn if the Si + Fe content is not more than 0.005% by weight.

It was found that the insulated light-reflective substrates as obtained in Examples each had a high reflectance also in a UV region. Thus, the substrate of the present invention has proved suitable for, for instance, a next-generation system using an ultraviolet LED or the like excellent in color rendering in an attempt to make an emitted light more approximate to sunlight.

## Claims

1. An insulated light-reflective substrate, comprising a substrate and an anodized film provided on a surface of the substrate, wherein:

   the substrate has at its surface an aluminum alloy layer of a thickness of not less than 10 $\mu$m;
   the aluminum alloy layer has an aluminum purity of 99.9% by weight or higher, with a total content of Si and Fe in the layer being not more than 0.005% by weight, and a content of inevitable impurities in the layer as components other than Al, Si, Fe, Ga and Zn being not more than 0.01% by weight;
   the anodized film has micropores each extending from a surface of the film in a direction of thickness; and
   a ratio of center line length to depth (length/depth ratio) of the micropores is 1.0 to 1.2.

2. The insulated light-reflective substrate according to claim 1, wherein the aluminum alloy layer has a Ga content of 5 to 25 ppm.

3. The insulated light-reflective substrate according to claim 1 or 2, wherein the aluminum alloy layer has a Zn content of 5 to 20 ppm.

**4.** The insulated light-reflective substrate according to any one of claims 1 to 3, whose total reflectance in visible region is 70% or higher.

**5.** The insulated light-reflective substrate according to any one of claims 1 to 4, whose total reflectance for light at a wavelength of 300 to 320 nm is 70% or higher.

**6.** The insulated light-reflective substrate according to any one of claims 1 to 5, which has a concaved portion for receiving a light-emitting source of a light-emitting device.

**7.** The insulated light-reflective substrate according to any one of claims 1 to 6, which has surface asperities at a mean wavelength of 0.01 to 100 $\mu$m.

**8.** The insulated light-reflective substrate according to any one of claims 1 to 7, wherein a surface area difference $\Delta S$ given by Equation (I):

$$\Delta S(\%) = (S_X - S_0)/S_0 \times 100 \qquad (I)$$

[where $S_X$ is an actual area of a 50 $\mu$m square region of a surface of the insulated light-reflective substrate that is determined by three-point approximation from three-dimensional data obtained by measuring the region with an atomic force microscope at $512 \times 512$ points, and So is a geometrically measured area of the region] is 1 to 50%.

**9.** The insulated light-reflective substrate according to any one of claims 1 to 8, wherein:

the anodized film is provided by anodizing treatment performed under at least two different conditions;
the anodized film includes at least two different anodizing treatment layers stacked in a direction of depth between the surface of the anodized film and an interface between the aluminum alloy layer and the anodized film; and
at least one out of the anodizing treatment layers has a perpendicular depth L which is given by Equations (a) to (c):

$$L = 1/2 \times m \times \lambda \times n_{avp}/n_{avp+1} \qquad (a)$$

$$n_{avp} = n_{Al2O3} \times (1 - D_p) + n_{air} \times D_p \qquad (b)$$

$$n_{avp+1} = n_{Al2O3} \times (1 - D_{p+1}) + n_{air} \times D_{p+1} \qquad (c)$$

[where m is an integer of 1 or higher, $\lambda$ is a wavelength of light to be reflected, $n_{avp}$ is a refractive index of an anodizing treatment layer p located toward the surface of the anodized film, $n_{avp+1}$ is a refractive index of an anodizing treatment layer p+1 so located under the anodizing treatment layer p as to be in contact with the layer p, $n_{Al2O3}$ is a refractive index of aluminum oxide, $n_{air}$ is a refractive index of air which is one in value, $D_p$ is a micropore porosity of the anodizing treatment layer p, and $D_{p+1}$ is a micropore porosity of the anodizing treatment layer p+1].

**10.** The insulated light-reflective substrate according to claim 9, wherein the anodized film includes two or three anodizing treatment layers different from one another in porosity, and one or two out of the anodizing treatment layers have the perpendicular depth L given by the Equations (a) to (c).

**11.** The insulated light-reflective substrate according to claim 9 or 10, wherein the anodized film includes two or three anodizing treatment layers different from one another in micropore aperture diameter.

**12.** The insulated light-reflective substrate according to any one of claims 1 to 11, which is a light-reflective substrate by which light emitted from a light-emitting element is reflected toward a plane through which the emitted light is to be viewed.

**13.** The insulated light-reflective substrate according to any one of claims 1 to 12, further comprising a wiring layer composed of a metal conductor and provided on the surface of the anodized film, wherein the insulated light-reflective substrate is used for mounting a light-emitting element.

**14.** An insulated light-reflective substrate manufacturing method for obtaining the insulated light-reflective substrate according to any one of claims 1 to 12, comprising:

a step of substrate fabrication for fabricating a substrate having at its surface an aluminum alloy layer which has an aluminum purity of 99.9% or higher, with a total content of Si and Fe in the layer being not more than 0.005% by weight, and a content of inevitable impurities in the layer as components other than Al, Si, Fe, Ga and Zn being not more than 0.01% by weight;
a step of graining treatment for subjecting a surface of the substrate to graining treatment; and
a step of anodizing treatment for subjecting the surface of the substrate after the graining treatment to anodizing treatment to form an anodized film.

**15.** The insulated light-reflective substrate manufacturing method according to claim 14 for obtaining the insulated light-reflective substrate according to claim 13, further comprising:

a step of wiring-layer formation following the step of anodizing treatment, for bringing metallic ink onto the anodized film by an ink-jet printing technique to form a wiring layer composed of a metal conductor.

**16.** A white LED light-emitting device, comprising the insulated light-reflective substrate according to claim 13, a blue LED light-emitting element provided on the wiring layer of the insulated light-reflective substrate, and a fluorescence emitter provided around and/or over the blue LED light-emitting element.

# FIG.1

# FIG.2

FIG.3

FIG.4

## FIG.5A

## FIG.5B

## FIG.6

## FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 55154564 U
- JP 2007251176 A
- JP 6135175 A
- JP 50040047 B
- JP 55074898 A
- JP 60036195 A
- JP 60203496 A
- JP 6055871 A
- JP 6024168 A
- JP 3008635 A
- JP 3066404 A
- JP 63065017 A
- JP 61162351 A
- JP 63104889 A
- JP 48028123 B
- GB 896563 A
- JP 52058602 A
- JP 3079799 A
- JP 55158298 A
- JP 56028898 A
- JP 52152302 A
- JP 54085802 A
- JP 60190392 A
- JP 58120531 A
- JP 63176187 A
- JP 1005889 A
- JP 1280590 A
- JP 1118489 A
- JP 1148592 A
- JP 1178496 A
- JP 1188315 A
- JP 1154797 A
- JP 2235794 A
- JP 3260100 A
- JP 3253600 A
- JP 4072079 A
- JP 4072098 A
- JP 3267400 A
- JP 1141094 A
- US 4276129 A
- US 4676879 A
- US 4203637 A
- JP 56123400 A
- JP 57059770 A
- JP 53012738 A
- JP 53032821 A
- JP 53032822 A
- JP 53032823 A
- JP 55122896 A

- JP 55132884 A
- JP 62127500 A
- JP 1052100 A
- JP 1052098 A
- JP 60067700 A
- JP 1230800 A
- JP 3257199 A
- JP 53012739 A
- JP 53032833 A
- JP 53032824 A
- JP 53032825 A
- JP 51007081 B
- JP 52133838 A
- JP 52133840 A
- JP 52133844 A
- JP 52133845 A
- JP 53149135 A
- JP 54146234 A
- US 4671859 A
- US 4661219 A
- US 4618405 A
- US 4600482 A
- US 4566960 A
- US 4566958 A
- US 4566959 A
- US 4416972 A
- US 4374710 A
- US 4336113 A
- US 4184932 A
- JP 5195300 A
- JP 2008270158 A
- JP 54081133 A
- JP 57047894 A
- JP 57051289 A
- JP 57051290 A
- JP 57054300 A
- JP 57136596 A
- JP 58107498 A
- JP 60200256 A
- JP 62136596 A
- JP 63176494 A
- JP 4176897 A
- JP 4280997 A
- JP 6207299 A
- JP 5024377 A
- JP 5032083 A
- JP 5125597 A
- JP 5195291 A
- JP 54012853 A

- JP 48045303 A
- JP 56012518 B
- JP 4004194 A
- JP 5202496 A
- JP 5179482 A

- JP 2008093652 A
- JP 2009068076 A
- JP 2009134007 A
- JP 2009139261 A